# EUROPEAN PATENT APPLICATION

(11) **EP 4 593 569 A1**
(43) Date of publication of application: **30.07.2025**
(21) Application number: 24215870.7
(22) Date of filing: 27.11.2024
(51) Int. Cl.: H10K 59/122, H10K 59/35, H10K 59/80

(54) **DISPLAY DEVICE AND METHOD FOR FABRICATING THE SAME**

(30) Priority: 23.01.2024 KR 20240009931
(71) Applicant: LG Display Co., Ltd., Seoul 07336 (KR)
(72) Inventor: KIM, Min Ki, 10845 Gyeonggi-do (KR); JO, Beom Gon, 10845 Gyeonggi-do (KR)
(74) Representative: Morrall, Jonathan Ian McLachlan

(57) **Abstract**

A display device can include a substrate in which a first sub-pixel, a second sub-pixel, and a third sub-pixel are disposed, a plurality of thin-film transistors respectively disposed to correspond to at least two sub-areas in each of the first to third sub-pixels, an insulating layer disposed on the plurality of thin-film transistors, a plurality of first electrodes disposed on the insulating layer, configured to correspond to the at least two sub-areas in each of the first to third sub-pixels, and respectively connected to the plurality of thin-film transistors, a trench located between the at least two sub-areas in each of the first to third sub-pixels, an organic electroluminescent compound layer disposed on the plurality of first electrodes, and a second electrode disposed on the organic electroluminescent compound layer.

## Description

### CROSS-REFERENCE TO RELATED APPLICATION

This application claims priority to and the benefit of Korean Patent Application No. 10-2024-0009931, filed in the Republic of Korea on January 23, 2024.

### BACKGROUND

### 1. Field

The present disclosure relates to a display device, and more specifically, to a display device that displays an image and a method for fabricating the same.

### 2. Discussion of Related Art

With the increase in usage of smartphones, computers, and other devices configured to easily access new information, the demand for display devices for displaying images has increased in various forms. Accordingly, various display devices such as liquid crystal display (LCD) devices, plasma display panel (PDP) devices, quantum-dot light emitting display (QLED) devices, and organic light-emitting display (OLED) devices have been used in recent years.

Recently, head-mounted displays (HMDs) including such display devices have been developed. The head-mounted display is a glasses-type monitor device of virtual reality (VR) or augmented reality (AR) that is worn in the form of glasses or a helmet to form a focus at a close distance in front of a user's eyes. For such a head-mounted display, reducing a distance between pixels and increasing a light-emitting area are important to improve performance. However, there is a limitation that a restricted degree of freedom of a fine metal mask (FMM) can decrease manufacturing efficiency of the display device.

### SUMMARY

An embodiment of the present disclosure is directed to providing a display device capable of improving a degree of fabrication freedom of a fine metal mask (FMM) by ensuring that an anode area of a thin-film transistor (TFT) corresponds to an emission area of an emission material layer (EML) in a ratio greater than or equal to 1:2. When the anode area of the thin-film transistor corresponds to an emission area of an emission material layer (EML) in a ratio greater than or equal to 1:2, manufacturing can be made easier, thereby leading to improved mass production of the FFM, which are necessary for implementing an ultra-high-resolution display. In addition, another embodiment of the present disclosure is directed to a method for fabricating the same.

The objectives of the present disclosure are not limited to the objectives mentioned above, and other objectives not mentioned will be clearly understood by those skilled in the art from the description below.

According to an embodiment of the present disclosure, there is provided a display device including a substrate in which a first sub-pixel, a second sub-pixel, and a third sub-pixel, each of which is divided into at least two sub-areas, are defined, a plurality of thin-film transistors respectively disposed to correspond to the at least two sub-areas in each of the first to third sub-pixels, an insulating layer provided on the plurality of thin-film transistors, a plurality of first electrodes disposed on the insulating layer to correspond to the at least two sub-areas in each of the first to third sub-pixels and respectively connected to the plurality of thin-film transistors, a trench located between the sub-areas divided in each of the first to third sub-pixels, an organic electroluminescent compound layer disposed on the first electrodes; and a second electrode formed on the organic electroluminescent compound layer, wherein the at least two sub-areas in each of the first to third sub-pixels have the same color.

According to another embodiment of the present disclosure, there is provided a display device including a substrate in which a first sub-pixel, a second sub-pixel, and a third sub-pixel, each of which is divided into at least two sub-areas, are defined, an insulating layer provided on the substrate, a reflective electrode provided on the insulating layer, a plurality of first electrodes disposed on the insulating layer to correspond to the at least two sub-areas in each of the first to third sub-pixels, a trench located between the at least two sub-areas divided in each of the first to third sub-pixels, an organic electroluminescent compound layer disposed on the first electrodes, and a second electrode formed on the organic electroluminescent compound layer, wherein the at least two sub-areas in each of the first to third sub-pixels have the same color.

According to still another embodiment of the present disclosure, there is provided a method for fabricating a display device, the method including preparing a substrate in which a first sub-pixel, a second sub-pixel, and a third sub-pixel, each of which is divided into at least two sub-areas, are defined, forming a plurality of first electrodes respectively disposed to correspond to the at least two sub-areas in each of the first to third sub-pixels, forming first to third hole layers on the plurality of first electrodes located in the sub-areas in the first to third sub-pixels, respectively, sequentially forming first to third emission material layers (EMI,s) on the first to third hole layers located on the sub-areas in the first to third sub-pixels using first to third fine metal masks (FMMs), forming an electron layer on the substrate including the first to third EMI,s, and forming a second electrode on the electron layer.

### BRIEF DESCRIPTION OF THE DRAWINGS

The above and other objects, features, and advantages of the present disclosure will become more apparent to those of ordinary skill in the art by describing exemplary embodiments thereof in detail with reference to the accompanying drawings, in which:
FIG. 1 is a perspective view illustrating a display device according to one embodiment of the present disclosure;
FIG. 2 is a plan view schematically illustrating a first substrate according to an example of an embodiment of the present disclosure;
FIG. 3 is a plan view schematically illustrating trenches of sub-pixels according to an example of an embodiment of the present disclosure;
FIG. 4 is a plan view illustrating an arrangement of the sub-pixels of FIG. 3;
FIG. 5 is a cross-sectional view taken along line I-I' of FIG. 4;
FIG. 6 is a cross-sectional view illustrating an example of a configuration of a first electrode, an emission material layer, and a second electrode in four sub-areas of a green sub-pixel in the display device according to one embodiment of the present disclosure;
FIG. 7 is a cross-sectional view taken along line II-II' of FIG. 4;
FIG. 8 is an enlarged cross-sectional view of portion A of FIG. 7;
FIG. 9 is a cross-sectional view illustrating an example of a configuration of a first electrode, an emission material layer, and a second electrode in two of four sub-areas of green, blue, and red sub-pixels in the display device according to one embodiment of the present disclosure;
FIG. 10 is a flowchart illustrating a fabricating process of the display device according to one embodiment of the present disclosure;
FIGS. 11A to 11H are cross-sectional views illustrating a method for fabricating the display device according to one embodiment of the present disclosure;
FIG. 12 is a plan view illustrating a case in which green (G)-emission material layers (EMI,s) are formed on sub-areas in green sub-pixels by applying a green fine metal mask (FMM) in the display device according to one embodiment of the present disclosure;
FIG. 13 is a plan view illustrating a case in which red (R)-EMI,s are formed on sub-areas in red sub-pixels by applying a red FMM in the display device according to one embodiment of the present disclosure;
FIG. 14 is a plan view illustrating a case in which blue (B)-EMLs are formed on sub-areas in blue sub-pixels by applying a blue FMM in the display device according to one embodiment of the present disclosure;
FIG. 15 is a plan view illustrating a case in which a pixel is configured with red, green, and blue sub-pixels in the display device according to one embodiment of the present disclosure;
FIG. 16 is a cross-sectional view taken along line II-II' of FIG. 4, in another embodiment of the present disclosure; and
FIG. 17 is a cross-sectional view specifically illustrating an example of a configuration of a first electrode, an emission material layer, and a second electrode in two of four sub-areas of green, red, and green sub-pixels in the display device according to another embodiment of the present disclosure.

### DETAILED DESCRIPTION OF THE EMBODIMENTS

Advantages and features of the present disclosure and a method of achieving the same should become clear with embodiments described in detail below with reference to the accompanying drawings. However, the present disclosure is not limited to the embodiments disclosed below and can be implemented with a variety of different forms. The present embodiments are merely provided to allow those skilled in the art to completely understand the scope of the present disclosure, and the present disclosure is defined only by the scope of the claims.

The figures, dimensions, ratios, angles, numbers, and the like disclosed in the drawings for describing the embodiments of the present disclosure are merely illustrative and are not limited to matters shown in the present disclosure. Further, in describing the present disclosure, detailed descriptions of well-known technologies will be omitted when it is determined that they can unnecessarily obscure the gist of the present disclosure.

Terms such as "including," "having," and "composed of" used herein are intended to allow other elements to be added unless the terms are used with the term "only." When a component is expressed in the singular form, it can include a case in which the plural form is included unless otherwise explicitly stated.

Components are interpreted as including an ordinary error range even when not expressly stated.

For the description of a positional relationship, for example, when the positional relationship between two parts is described as "on," "above," "below," "next to," and the like, one or more parts can be interposed therebetween unless the term "immediately" or "directly" is used in the expression.

When an element or layer is disposed "on" another element or layer, the element is disposed directly on another element or layer or disposed on another element another layer with still another element therebetween.

In addition, the terms "first," "second," and the like can be used herein to describe various components, the components are not limited by the terms. These terms are used only to distinguish one component from another and may not define order or sequence. Accordingly, a first component discussed below could be termed a second component without departing from the teachings of the present disclosure.

Like reference numerals generally denote like elements throughout the specification.

The size and thickness of each component illustrated in the drawings are shown for convenience of description, and the present disclosure is not necessarily limited to the size and thickness of the component illustrated.

The features of various embodiments of the present disclosure can be partially or entirely bonded to or combined with each other. The embodiments can be interoperated and performed in various ways technically and can be carried out independently of or in association with each other. Further, the term "can" encompasses all the meanings and coverages of the term "may."

Hereinafter, an example of a display device according to the present disclosure will be described in detail with reference to the accompanying drawings. In adding reference numerals to components in each drawing, the same components can have the same reference numerals as much as possible even though they are indicated on different drawings. All the components of each display device according to all embodiments of the present disclosure are operatively coupled and configured.

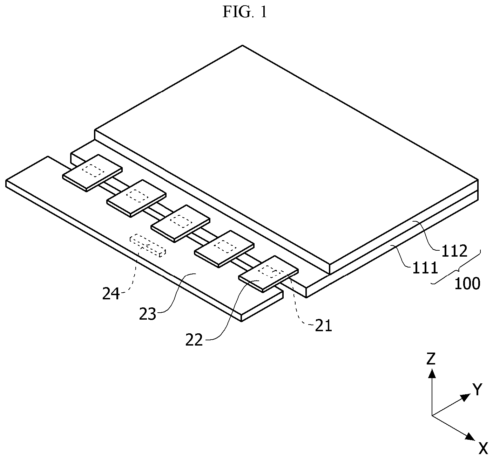

FIG. 1 is a perspective view illustrating a display device according to one embodiment of the present invention.

Referring to FIG. 1, the display device according to one embodiment of the present disclosure includes a display panel 100, source driver integrated circuits (hereinafter referred to as "source driver ICs") 21, flexible films 22, a circuit board 23, and a timing controller 24.

The display panel 100 includes a first substrate 111 and a second substrate 112. The second substrate 112 can be an encapsulation substrate. Gate lines, data lines, and pixels are formed on one surface of the first substrate 111 facing the second substrate 112. The second substrate can be disposed on a portion of the first substrate. However, the first substrate can include an exposed portion that does not have the second substrate disposed thereon.

Pixels can be provided in an area defined by an intersection structure of the gate lines and the data lines. Each of the pixels can include a light-emitting element that includes a thin-film transistor, a first electrode, an emission material layer, and a second electrode. Each of the pixels is provided in an area defined by an intersection structure of the gate lines and the data lines using the thin-film transistor.

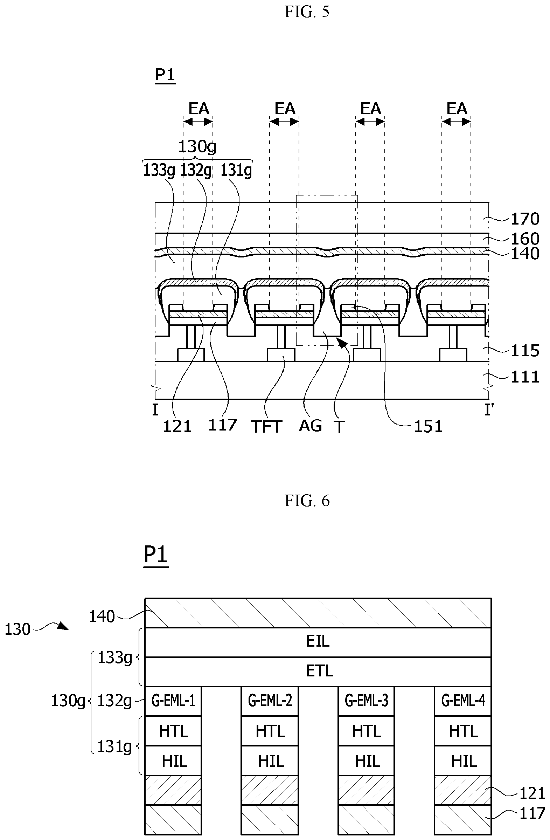

Each of the pixels is configured to supply a predetermined current to an organic light-emitting element according to a data voltage of the data line when a gate signal from the gate line is input thereto using a thin-film transistor. Accordingly, the organic light-emitting element of each of the pixels can emit light with a predetermined brightness based on the predetermined current. A structure of each of the pixels will be described later with reference to FIG. 5.

Additionally, the display panel 100 can be divided into a display area in which pixels are disposed to display an image, and a non-display area in which an image is not displayed. The gate lines, the data lines, and the pixels can be disposed in the display area. A gate driver and pads can be disposed in the non-display area. In addition, in a variation, none or some of the gate lines, the data lines, and the pixels are disposed in the non-display area.

The gate driver is configured to supply gate signals to the gate lines according to a gate control signal input from the timing controller 24. The gate driver can be disposed in the non-display area outside one side or both sides of the display area of the display panel 100 by a gate driver-in-panel (GIP) method. Alternatively, the gate driver can be fabricated as a driving chip, can be mounted on a flexible film, and can be attached to the non-display area outside one side or both sides of the display area of the display panel 100. The gate driver can be attached to the non-display area by a tape automated bonding (TAB) method, but a method of attachment is not limited thereto.

The source driver IC 21 is configured to receive digital video data and a source control signal from the timing controller 24. The source driver IC 21 converts the digital video data into analog data voltages according to the source control signal, and supplies the analog data voltages to the data lines. When the source driver IC 21 is fabricated as a driving chip, the source driver IC 21 can be mounted on the flexible film 22. In addition, when the source driver IC 21 is fabricated as a driving chip, the source driver IC 21 can be mounted by a chip-on-film (COF) method or a chip-on-plastic (COP) method, but a method of mounting is not limited thereto.

Further, pads, such as data pads, can be disposed in the non-display area of the display panel 100. Lines connecting the pads to the source driver IC 21 and lines connecting the pads to lines of the circuit board 23 can be disposed in the flexible film 22. The flexible film 22 can be attached onto the pads using an anisotropic conducting film, so that the pads can be connected to the lines of the flexible film 22.

The circuit board 23 can be attached onto the flexible films 22. However, in another embodiment, the flexible films can be attached to the circuit board 23. In addition, a plurality of circuits implemented as driving chips can be mounted on the circuit board 23. For example, the timing controller 24 can be mounted on the circuit board 23. The circuit board 23 can be a printed circuit board or a flexible printed circuit board, but is not limited thereto.

The timing controller 24 is configured to receive digital video data and a timing signal from an external system board through a cable of the circuit board 23. The timing controller 24 is configured to generate a gate control signal for controlling an operation timing of the gate driver and a source control signal for controlling the source driver ICs 21 based on the timing signal. The timing controller 24 is configured to supply the gate control signal to the gate driver, and supply the source control signal to the source driver ICs 21.

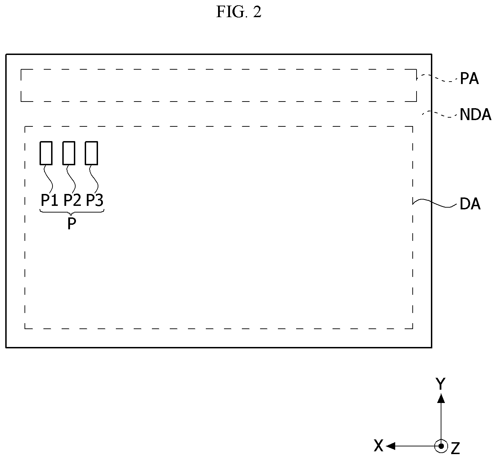

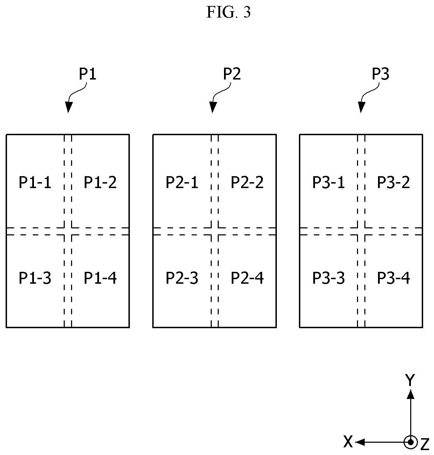

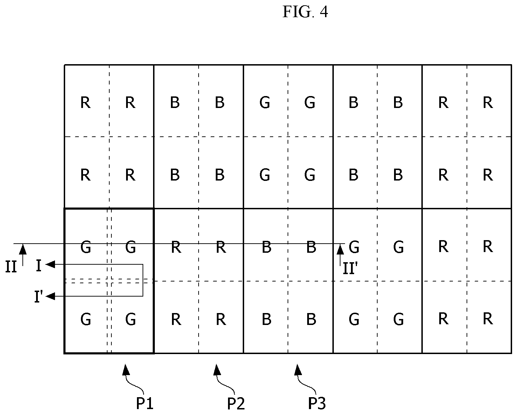

FIG. 2 is a plan view schematically illustrating the first substrate, FIG. 3 is a plan view schematically illustrating trenches of sub-pixels, and FIG. 4 is a plan view illustrating an arrangement of the sub-pixels of FIG. 3.

Referring to FIGS. 2 to 4, the first substrate 111 is divided into a display area DA and a non-display area NDA, and a pad area PA in which pads are disposed. In addition, the pad area PA can be disposed in the non-display area NDA.

Data lines and gate lines intersecting the data lines are formed in the display area DA. In addition, in the display area DA, pixels P that are configured to display an image in a form of a matrix are formed in an intersection area of the data lines and the gate lines.

Each of the pixels P can include a first sub-pixel P1, a second sub-pixel P2, and a third sub-pixel P3. The first sub-pixel P1 can be configured to emit green light, the second sub-pixel P2 can be configured to emit red light, and the third sub-pixel P3 can be configured to emit blue light. However, the present disclosure is not necessarily limited thereto. For example, each of the first sub-pixel P1, the second sub-pixel P2, and the third sub-pixel P3 can be configured to emit one of the green light, the red light, or the blue light. In addition, each of the pixels can further include a fourth sub-pixel that emits white (W) light. In addition, an arrangement sequence of the sub-pixels P1, P2, and P3 can be changed in various ways.

Referring to FIGS. 3 to 4, the first sub-pixel P1 can be divided into at least two sub-areas, e.g., four first sub-areas P1-1, P1-2, P1-3, and P1-4, the second sub-pixel P2 can be divided into four second sub-areas P2-1, P2-2, P2-3, and P2-4, and the third sub-pixel P3 can be divided into four third sub-areas P3-1, P3-2, P3-3, and P3-4. However, the present disclosure is not necessarily limited thereto. For example, the first sub-pixel to third sub-pixel can be divided into less than four sub-areas or more than four sub-areas.

In the present embodiment, the case in which each of the sub-pixels P1, P2, and P3 are divided into four sub-areas is described by way of example, but each of the sub-pixels P1, P2, and P3 can be defined by being divided into at least two sub-areas.

As described above, a degree of fabrication freedom of a fine metal mask (FMM) can be improved by four times by ensuring that an anode area of a thin-film transistor corresponds to an emission area of an emission material layer (EML), i.e., the area that requires the FMM, in at least a 1:2 ratio, rather than conventional 1:1 matching, in order to overcome the manufacturing technology and mass productivity of an FMM required for R/G/B implementation in ultra-high-resolution displays. In another embodiment, a ratio of the anode area to the emission area can be in a 1:4 ratio. However, the configuration is not limited thereto.

In particular, by dividing each of the first to third sub-pixels P1, P2, and P3 into at least two or more sub-areas, such as four sub-areas P1-1 to P1-4, P2-1 to P2-4, or P3-1 to P3-4, the difficulty of the fabrication process of the FMM can be reduced by increasing an area of the EML to be formed by four times using the FMM. In addition, a problem of mask clogging in the FMM can be reduced through the increased opening area, thereby increasing production efficiency.

In the present embodiment, the first sub-pixel P1 is a green (G) sub-pixel, the second sub-pixel P2 is a red (R) sub-pixel, and the third sub-pixel P3 is a blue (B) sub-pixel. However, the present disclosure is not limited thereto.

Here, when the gate signal is input through the gate line, each of the sub-pixels P1, P2, and P3 is configured to supply a predetermined current to the light-emitting element according to the data voltage of the data line. Accordingly, the light-emitting element of each of the sub-pixels P1, P2, and P3 can emit light with a predetermined brightness based on a predetermined current. In addition, a power voltage is supplied to a power line. The power line supplies the power voltage to each of the sub-pixels P1, P2, and P3.

Hereinafter, a structure of the sub-pixels P1, P2, and P3 according to one embodiment of the present disclosure will be described in more detail. Here, among the four sub-areas of each of the sub-pixels P1, P2, and P3, two sub-areas P1-1 and P1-2, P2-1 and P2-2, or P3-1 and P3-2 will be described by way of example.

FIG. 5 is a cross-sectional view taken along line I-I' of FIG. 4, and FIG. 6 is a cross-sectional view specifically illustrating an example of a configuration of a first electrode, an emission material layer, and a second electrode in the four sub-areas of the green sub-pixel in the display device according to one embodiment of the present disclosure.

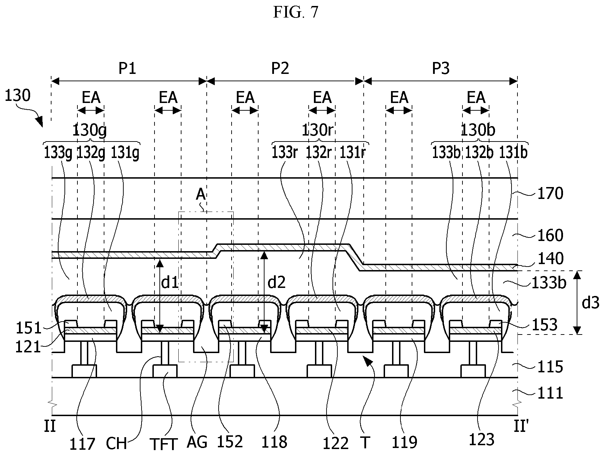

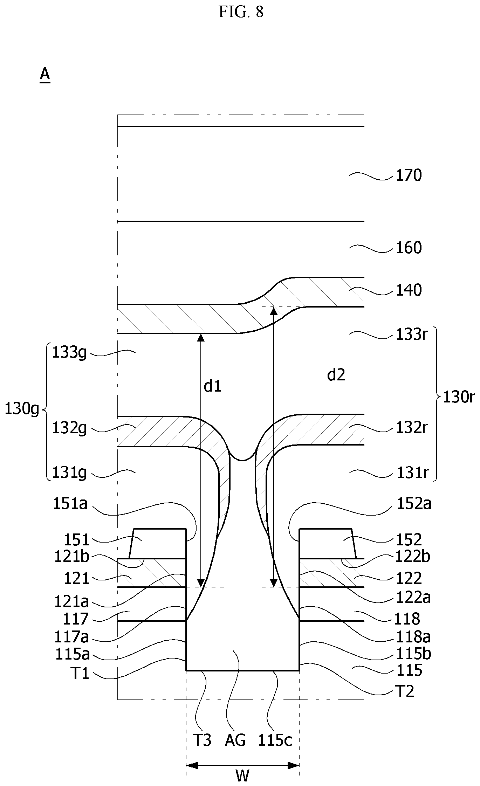

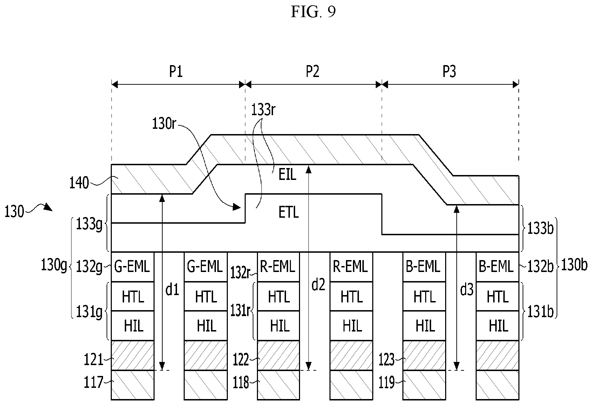

FIG. 7 is a cross-sectional view taken along line II-II' of FIG. 4, FIG. 8 is an enlarged cross-sectional view of portion A of FIG. 7, and FIG. 9 is a cross-sectional view specifically illustrating an example of a configuration of a first electrode, an emission material layer, and a second electrode in two of the four sub-areas of the green, blue, and red sub-pixels in the display device according to one embodiment of the present disclosure.

Referring to FIGS. 5 to 9, the first substrate 111 is divided into a display area DA and a non-display area NDA, and a pad area PA in which pads are disposed can be disposed in the non-display area NDA.

Data lines and gate lines intersecting the data lines are formed in the display area DA. In addition, pixels P that display an image in the form of a matrix are formed in the display area DA in an intersection area of the data lines and the gate lines.

Each of the pixels P can include a first sub-pixel P1, a second sub-pixel P2, and a third sub-pixel P3. The first sub-pixel P1 can be provided to emit green light, the second sub-pixel P2 can be provided to emit red light, and the third sub-pixel P3 can be provided to emit blue light. However, the present disclosure is not necessarily limited thereto. Each of the pixels can further include a fourth sub-pixel that emits white (W) light. In addition, an arrangement sequence of the sub-pixels P1, P2, and P3 can be changed in various ways.

Referring to FIG. 3, the first sub-pixel P1 may be divided into four first sub-areas P1-1, P1-2, P1-3, and P1-4, the second sub-pixel P2 may be divided into four second sub-areas P2-1, P2-2, P2-3, and P2-4, and the third sub-pixel P3 may be divided into four third sub-areas P3-1, P3-2, P3-3, and P3-4.

In the present embodiment, the first sub-pixel P1 is a green sub-pixel, the second sub-pixel P2 is a red sub-pixel, and the third sub-pixel P3 is a blue sub-pixel. However, the present disclosure is not limited thereto.

Here, when the gate signal is input through the gate line, each of the sub-pixels P1, P2, and P3 is configured to supply a predetermined current to the light-emitting element according to data voltage of the data line. Accordingly, the light-emitting element of each of the sub-pixels P1, P2, and P3 can emit light with a predetermined brightness based on a predetermined current. In addition, a power voltage is supplied to a power line. The power line is configured to supply the power voltage to each of the sub-pixels P1, P2, and P3.

Hereinafter, a structure of the sub-pixels P1, P2, and P3 according to one embodiment of the present disclosure will be described in more detail. Here, the case in which the green sub-pixel P1 is divided into four sub-areas P1-1, P1-2, P1-3, and P1-4 will be described by way of example.

Referring to FIGS. 5 and 7, a driving transistor TFT, an insulating layer 115, first, second, and third reflective electrodes 117, 118, and 119, first electrodes 121, 122, and 123, an emission material layer 130, a second electrode 140, an encapsulation film 170, a capping layer 160, first to third banks 151, 152, and 153, and trenches T are formed on one surface of the first substrate 111 facing the second substrate 112.

The first substrate 111 can be made of glass or plastic, but is not necessarily limited thereto, and can be made of a semiconductor material such as a silicon wafer. The first substrate 111 can be made of a transparent material or an opaque material.

The display device according to one embodiment of the present disclosure can be provided in a top emission type in which emitted light is emitted toward an upper portion of the display panel 100, but the present disclosure is not necessarily limited thereto. When the display device according to one embodiment of the present disclosure is provided in the top emission type in which emitted light is emitted toward the upper portion of the display panel 100, the first substrate 111 can be made of either an opaque material or a transparent material.

Meanwhile, when the display device according to one embodiment of the present disclosure is provided in a bottom emission type in which emitted light is emitted toward a lower portion of the display panel 100, the first substrate 111 can be made of a transparent material.

Referring to FIG. 7, a circuit element that includes various signal lines, a thin-film transistor, a capacitor and the like can be formed on the first substrate 111 for each of the sub-pixels P1, P2, and P3. The signal lines can include a gate line, a data line, a power line, and a reference line. In addition, the thin-film transistor can include a switching thin-film transistor, the driving transistor TFT and a sensing thin-film transistor.

The switching thin-film transistor is configured to switch according to the gate signal supplied to the gate line, and serves to supply the data voltage supplied from the data line to the driving thin-film transistor.

The driving transistor TFT is configured to switch according to the data voltage supplied from the switching thin-film transistor to generate a data current from power supplied from the power line and serves to supply the generated data current to the first electrode 121.

The sensing thin-film transistor is configured to sense a threshold voltage deviation of the driving thin-film transistor, which is a cause of image degradation, and supply the current of the driving thin-film transistor to the reference line in response to a sensing control signal supplied from the gate line or a separate sensing line.

The capacitor is configured to maintain the data voltage supplied from the driving transistor TFT for one frame, and is connected to each of a gate terminal and a source terminal of the driving transistor TFT.

The insulating layer 115 is disposed on the circuit element that includes the driving transistor TFT. The insulating layer 115 can be formed of an inorganic film, for example, a silicon oxide (SiOx) film, a silicon nitride (SiNx) film, or a multilayer film of SiOx and SiNx, but the present disclosure is not limited thereto. The insulating layer 115 can be formed of an acrylic resin, an epoxy resin, a phenolic resin, a polyamide resin, a polyimide resin, or the like. Alternatively, the insulating layer 115 can be formed of a multilayer film that includes at least one inorganic film and at least one organic film.

The first to third reflective electrodes 117, 118, and 119 and the first electrodes 121, 122, and 123 are disposed on the insulating layer 115 respectively for the sub-pixels P1, P2, and P3.

Referring to FIG. 5, the first sub-pixel P1 is divided into four sub-areas P1-1, P1-2, P1-3, and P1-4, and the first reflective electrode 117 and the first electrode 121 are formed in each of the four sub-areas P1-1, P1-2, P1-3, and P1-4.

In addition, the second sub-pixel P2 is divided into four sub-areas P2-1, P2-2, P2-3, and P2-4, and the second reflective electrode 118 and the first electrode 122 are formed in each of the four sub-areas P2-1, P2-2, P2-3, and P2-4.

In addition, the third sub-pixel P3 is divided into four sub-areas P3-1, P3-2, P3-3, and P3-4, and the third reflective electrode 119 and the first electrode 123 are formed in each of the four sub-areas P3-1, P3-2, P3-3, and P3-4

The first to third reflective electrodes 117, 118, and 119 can serve as reflectors that reflect light emitted from the organic electroluminescent compound layer 130. In addition, the first to third reflective electrodes 117, 118, and 119 can be formed of silver (Ag), aluminum (Al), and molybdenum (Mo), or alloys of the above materials, including an alloy of silver (Ag) and magnesium (Mg), which have high electrical conductivity and low work function, but are not limited thereto.

Referring to FIG. 7, the first electrodes 121, 122, and 123 are connected to the driving transistor TFT. Specifically, the first electrodes 121, 122, and 123 are connected to the source terminal or a drain terminal of the driving transistor TFT through a contact hole CH that passes through the insulating layer 115, so that a signal from the driving transistor TFT can be applied to the first electrodes 121, 122, and 123.

The first electrodes 121, 122, and 123 can be made of one of a transparent conductive metal material, a semi-transmissive conductive metal material, and a metal material with high reflectivity, but are not limited thereto.

When the display device is provided in a top emission type, the first electrodes 121, 122, and 123 can be formed of a metal material with high reflectivity or a stacked structure of a metal material with high reflectivity and a transparent conductive material. For example, the first electrodes 121, 122, and 123 can be formed of a metal material with high reflectivity, such as a stacked structure (Ti/Al/Ti) of Al and titanium, a stacked structure (ITO/Al/ITO) of Al and indium tin oxide (ITO), an Ag alloy, and a stacked structure (ITO/Ag alloy/ITO) of Ag alloy and ITO. The Ag alloy can be an alloy of silver (Ag), palladium (Pd), copper (Cu), and the like. However, the first electrodes 121, 122, and 123 are not limited thereto, and can be formed of other materials.

When the display device is provided in a bottom emission type, the first electrodes 121, 122, and 123 can be formed of a transparent conductive material (TCO) such as ITO and IZO, which can transmit light, or a semi-transmissive conductive material such as magnesium (Mg), silver (Ag), or an alloy of Mg and Ag. These first electrodes 121, 122, and 123 can be anodes. However, the first electrodes 121, 122, and 123 are not limited thereto, and can be formed of other materials.

The first, second, and third banks 151, 152, and 153 are disposed on the first electrodes 121, 122, and 123 and configured to define an emission area EA in each of a plurality of first, second, and third sub-pixels P1, P2, and P3. That is, in each of the first to third sub-pixels P1, P2, and P3, the area in which the first, second, and third banks 151, 152, and 153 are not formed and the first electrodes 121, 122, and 123 are exposed becomes the emission area EA. On the other hand, an area outside of the emission area EA is a non-emission area.

In addition, the first bank 151 can define the emission area EA in each of first-first to first-fourth sub-areas P1-1, P1-2, P1-3, and P1-4 divided from the first sub-pixel P1. In the present embodiment, the first sub-pixel P1 is described by taking the green sub-pixel as an example, but the present disclosure is not limited thereto.

In addition, the second bank 152 can define the emission area EA in each of second-first to second-fourth sub-pixels P2-1, P2-2, P2-3, and P2-4 divided from the second sub-pixel P2. In the present embodiment, the second sub-pixel P2 is described by taking the red sub-pixel as an example, but the present disclosure is not limited thereto.

In addition, the third bank 153 can define the emission area EA in each of third-first to third-fourth sub-pixels P3-1, P3-2, P3-3, and P3-4 divided from the third sub-pixel P3. In the present embodiment, the third sub-pixel P3 is described by taking the blue sub-pixel as an example, but the present disclosure is not limited thereto.

The first, second, and third banks 151, 152, and 153 are formed at edges of the first electrodes 121, 122, and 123, respectively, so that it is possible to prevent a problem in which current is concentrated at the ends of the first electrodes 121, 122, and 123, which reduces light emission efficiency.

Meanwhile, the first, second, and third banks 151, 152, and 153 according to one embodiment of the present disclosure are formed such that trenches T formed between the sub-pixels P1, P2, and P3 are exposed. That is, the first, second, and third banks 151, 152, and 153 are formed at edges of upper surfaces of the first electrodes 121, 122, and 123 formed in the sub-pixels P1, P2, and P3, respectively. However, in another embodiment, the first, second, and third banks 151, 152, and 153 can be formed on side surfaces of the first electrodes 121, 122, and 123, respectively.

These first, second, and third banks 151, 152, and 153 can be formed of an inorganic film, for example, a SiOx film, a SiNx film, or a multilayer film of SiOx and SiNx, but the present disclosure is not necessarily limited thereto. In another embodiment, the first, second, and third banks 151, 152, and 153 can be formed of an organic film such as an acrylic resin, an epoxy resin, a phenolic resin, a polyamide resin, or a polyimide resin. However, the first, second, and third banks 151, 152, and 153 are not limited thereto, and can be formed of other materials.

The trenches T are formed in the insulating layer 115, the first electrodes 121, 122, and 123, and the first, second, and third banks 151, 152, and 153. The trenches T can be formed between the sub-pixels P1, P2, and P3 and be configured to pass through the first electrodes 121, 122, and 123, the first, second, and third reflective electrodes 117, 118, and 119, and the first, second, and third banks 151, 152, and 153 such that a portion of the insulating layer 115 is recessed, but the present disclosure is not necessarily limited thereto. The trench T can also be formed to pass through the insulating layer 115. Hereinafter, for convenience of description, the trench T can represent a portion that passes through the first electrode 121 and the first bank 151, or is recessed from or passes through the insulating layer 115. However, the present disclosure is not limited thereto, and the trench T can also be applied in the same manner to the first electrodes 122 and 123, the second and third reflective electrodes 118 and 119, and the second and third banks 152 and 153 of the second and third sub-pixels P2 and P3.

More specifically, referring to FIG. 8, the trench T can be formed in a direction from an upper surface of the first bank 151 toward the first substrate 111. This trench T includes a first surface T1, a second surface T2, and a third surface T3 connecting the first surface T1 and the second surface T2.

The first surface T1 of the trench T can include a side surface 151a of the first bank 151, a side surface 121a of the first electrode 121, a side surface 117a of the first reflective electrode 117, and a first side surface 115a of the insulating layer 115, which are provided in one first sub-pixel P1. The trench T can be formed to expose the side surface 151a of the first bank 151 provided in one first sub-pixel P1. In addition, the trench T can be formed to expose the side surface 121a of the first electrode 121 provided in one first sub-pixel P1. In this case, the side surface 121a of the first electrode 121 provided in one sub-pixel can be exposed in the trench T without being covered by the first bank 151 formed at an edge of an upper surface 121b of the first electrode 121.

The second surface T2 of the trench T can include a side surface 152a of the second bank 152, a side surface 122a of the first electrode 122, a side surface 118a of the second reflective electrode 118, and a second side surface 115b of the insulating layer 115, which are provided in another second sub-pixel P2 disposed adjacent to the one sub-pixel. The trench T can be formed to expose the side surface 152a of the second bank 152 provided in another second sub-pixel P2. In addition, the trench T can be formed to expose the side surface 122a of the first electrode 122 and the side surface 118a of the second reflective electrode 118 provided in another second sub-pixel P2. In this case, the side surface 122a of the first electrode 122 provided in another second sub-pixel P2 can be exposed in the trench T without being covered by the second bank 152 formed at an edge of an upper surface 122b of the first electrode 122.

The third surface T3 of the trench T is provided between the first surface T1 and the second surface T2, and connects the first surface T1 and the second surface T2 to each other. One end of the third surface T3 of the trench T is connected to the first surface T1, and the other end thereof is connected to the second surface T2. The third surface T3 of the trench T can include an inner side bottom surface 115c connecting the first side surface 115a and the second side surface 115b of the insulating layer 115 to each other.

The first electrodes 121, 122, and 123 can be respectively formed for the sub-pixels P1, P2, and P3. In addition, the banks 151, 152, and 153 can be formed at the edges of the upper surfaces of the first electrodes 121, 122, and 123 provided in the first to third sub-pixels P1, P2, and P3, respectively. That is, the trench T can also be formed in each of the first to third sub-pixels P1, P2, and P3, divided into four first sub-areas P1-1 to P1-4, four second sub-areas P2-1 to P2-4, and four third sub-areas P3-1 to P3-4.

The trench T separates the first electrodes 121, 122, and 123 respectively formed in the first to third sub-pixels P1, P2, and P3 from each other to expose the side surface of each of the first electrodes 121, 122, and 123. In this case, the trench T can have a width equal to a separation distance between the first electrodes 121, 122, and 123. However, the present disclosure is not necessarily limited thereto.

Specifically, referring to FIG. 7, the trench T can be provided between the first sub-pixel P1 and the second sub-pixel P2. Further, the trench T can have a width equal to the separation distance between the first electrode 121 provided in the first sub-pixel P1 and the first electrode 122 provided in the second sub-pixel P2. In addition, the trench T provided between the second sub-pixel P2 and the third sub-pixel P3 can have a width equal to the separation distance between the first electrode 122 provided in the second sub-pixel P2 and the first electrode 123 provided in the third sub-pixel P3. However, the present disclosure is not necessarily limited thereto.

In addition, the trench T separates the first, second, and third banks 151, 152, and 153 respectively formed in the first to third sub-pixels P1, P2, and P3 from each other to expose the side surface of each of the first, second, and third banks 151, 152, and 153.

In this case, the trench T can have a width equal to a separation distance between the banks 151, 152, and 153. Specifically, the trench T provided between the first sub-pixel P1 and the second sub-pixel P2 can have a width equal to the separation distance between the first bank 151 provided in the first sub-pixel P1 and the second bank 152 provided in the second sub-pixel P2. In addition, the trench T provided between the second sub-pixel P2 and the third sub-pixel P3 can have a width equal to the separation distance between the second bank 152 provided in the second sub-pixel P2 and the third bank 153 provided in the third sub-pixel P3. Further, the widths of each of the trenches T can be equal to each other. However, in another embodiment, the widths of each of the trenches T does not have to be equal to each other.

The width of the trench T can be determined in consideration of a thickness and a deposition method of the emission material layer 130. When each of first organic electroluminescent compound layers 130g includes a first hole layer 131g, a first EML 132g, and a first electron layer 133g, the trench T can have a width such that the first hole layers 131g and the first EMI,s 132g are disconnected from each other in the trench T while the first electron layers 133g are connected in the trench T. In this case, the first EML 132g can be a green (G) EML. However, the present disclosure is not limited thereto.

Referring to FIG. 8, when a width of the trench T is formed to be small, the first EML 132g and a second EML 132r of the adjacent sub-pixels can be connected to each other. Specifically, the trench T can be formed between the first sub-pixel P1 and the second sub-pixel P2, and the hole layer 131g, the EML 132g, and the electron layer 133g of the organic electroluminescent compound layer 130g can be sequentially stacked in the trench T. For example, when the width of the trench T is formed as small as 0.09 µm, the first hole layer 131g stacked in the first sub-pixel P1 and a second hole layer 131r stacked in the second sub-pixel P2 can be in contact with each other at an upper portion of the trench T. Due to this, the first EML 132g stacked on the first hole layer 131g in the first sub-pixel P1 is connected to that in the second sub-pixel P2, which can cause a leakage current between the adjacent sub-pixels P1 and P2. However, the trench T serves to block a leakage current from generating between adjacent sub-pixels P1 and P2. Thus, the trench T serves to prevent the adjacent sub-pixel P2 from emitting light when the first sub-pixel P1 emits light by blocking the connection between the EML 132g and the EML 132r of the adjacent sub-pixel P2 thus preventing the generation of the leakage current between the first sub-pixel P1 and the second sub-pixel P2.

In order to prevent the first hole layer 131g stacked in the first sub-pixel P1 and the second hole layer 131r stacked in the second sub-pixel P2 from coming into contact with each other at the upper portion of the trench T, in the display device according to one embodiment of the present invention, a width of the trench T can be formed to be greater than or equal to 0.09 µm. However, the present disclosure is not necessarily limited thereto. On the other hand, when the width of the trench T is formed to be large, the second electrodes 140 of the adjacent sub-pixels can be disconnected from each other in the trench T without being connected to each other. For example, when the width of the trench T is formed to be greater than or equal to 0.20 µm, the second electrode 140 stacked in the first sub-pixel P1 and the second electrode 140 stacked in the second sub-pixel P2 can be disconnected from each other by the trench T.

At this time, the second electrode 140 stacked in the first sub-pixel P1 can be formed to correspond to the first surface T1 of the trench T. The second electrode 140 stacked in the second sub-pixel P2 can be formed to correspond to the second surface T2 of the trench T. The side surface 121a of the first electrode 121 provided in the first sub-pixel P1 can still be exposed. In this case, the side surface 121a of the first electrode 121 can come into contact with the second electrode 140 and a short circuit can occur therebetween. Alternatively, the side surface 122a of the first electrode 122 provided in the second sub-pixel P2 can still be exposed. In this case, the side surface 122a of the first electrode 122 can come into contact with the second electrode 140 and a short circuit can occur therebetween.

In the display device according to one embodiment of the present invention, a width W of the trench T can be formed to be less than 0.20 µm such that the second electrode 140 stacked in the first sub-pixel P1 and the second electrode 140 stacked in the second sub-pixel P2 are connected to each other.

In an embodiment, the organic electroluminescent compound layer 130 includes organic electroluminescent compound layers 130g, 130r, and 130b located in the first, second, and third sub-pixels P1, P2, and P3, respectively.

The organic electroluminescent compound layer 130 is disposed on the first electrodes 121, 122, and 123. The organic electroluminescent compound layer 130 can be a white emission material layer that is configured to emit a white light. In this case, the organic electroluminescent compound layer 130 can be a common layer commonly formed in the sub-pixels P1, P2, and P3.

As shown in FIG. 9, the organic electroluminescent compound layer 130 includes a hole layer 131 including a hole injection layer HIL and a hole transport layer HTL, an EML 132, and an electron layer 133 including an electron transport layer ETL and an electron injection layer EIL.

Referring to FIGS. 7-9, the organic electroluminescent compound layer 130 includes the first organic electroluminescent compound layer 130g located in the first sub-pixel P1, a second organic electroluminescent compound layer 130r located in the second sub-pixel P2, and a third organic electroluminescent compound layer 130b located in the third sub-pixel P3.

In addition, the hole layer 131 includes the first hole layer 131g located in the first sub-pixel P1, the second hole layer 131r located in the second sub-pixel P2, and a third hole layer 131b located in the third sub-pixel P3.

The electron layers 133g, 133r, and 133b are located on upper portions of first, second, and third EMI,s 132g, 132r, and 132b, and are disposed to cover an entire surface of the first to third sub-pixels P1, P2, and P3.

Referring to FIG. 7, in order to vary cavity lengths d1, d2, and d3 between the second electrode 140 and the first to third reflective electrodes 117, 118, and 119 respectively located in the sub-pixels P1, P2, and P3, a thickness of a first electron layer 133g located in the first sub-pixel P1 can be formed to be less than a thickness of a second electron layer 133r located in the second sub-pixel P2, and to be greater than a thickness of a third electron layer 133b located in the third sub-pixel P3. In addition, the thickness of the second electron layer 133r located in the second sub-pixel P2 can be greater than the thickness of a third electron layer 133b located in the third sub-pixel P3. However, in other embodiments, the thickness of each the first to third sub-pixel P1, P2, and P3 can be varied.

In this case, the electron transport layer ETL constituting the first to third electron layers 133g, 133r, and 133b can be formed to have a different thickness. Here, in the present embodiment, the case in which the electron transport layer ETL forming the electron layer is formed to have a different thickness is described by way of example, but the hole transport layer HTL forming the hole layer can be formed to have a different thickness.

In addition, the EML 132 includes the first EML 132g located in the first sub-pixel P1 and configured to emit green light, and the second EML 132r located in the second sub-pixel P2 and configured to emit red light, and a third EML 132b located in the third sub-pixel P3 and configured to emit blue light. However, the present disclosure is not necessarily limited thereto.

In addition, the EML is formed by applying a fine metal mask (FMM). For example, in order to form the first EML 132g in the green first sub-pixel P1 among the first to third sub-pixels P1, P2, and P3, a green emission material layer material is deposited while an FMM is disposed on upper portions of the first hole layers 131g of a plurality of first sub-pixels P1 corresponding to the green sub-pixel, thereby forming the first EML 132g in the green first sub-pixel P1. The second and third EMI,s 132r and 132b can be formed similarly to the first EML 132g. At this time, since each of the plurality of first sub-pixels P1 is divided into four sub-areas P1-1, P1-2, P1-3, and P1-4, the first EML 132g can be easily formed using the FMM, thereby improving the degree of freedom of FMM fabrication by more than four times.

In addition, the red second EML 132r of the second sub-pixel P2 and the third blue EML 132b of the third sub-pixel P3 can be formed by using separate FMMs. Accordingly, even in the case of each of a plurality of second sub-pixels P2 and each of a plurality of third sub-pixels P3, which are divided into four sub-areas P2-1, P2-2, P2-3, and P2-4 and four sub-areas P3-1, P3-2, P3-3, and P3-4, FMMs can be used to form the second and third EMLs 132r and 132b, thereby improving the degree of freedom of FMM fabrication by more than four times.

The first EML 132g formed in the first sub-pixel P1, the second EML 132r formed in the second sub-pixel P2, and the third EML 132b formed in the third sub-pixel P3 are disconnected from each other due to a stepped portion of the trench T, as shown in FIG. 7. In addition, the first EML 132g formed in the first sub-pixel P1 and the second EML 132r formed in the second sub-pixel P2 are not in contact with each other at the upper portion of the trench T.

Since the first to third EMI,s 132g, 132r, and 132b respectively of the first to third sub-pixels P1, P2, and P3 are disconnected from each other inside the trench T to avoid leakage current, it is difficult for charges to move through the first to third EMI,s 132g, 132r, and 132b between the adjacent sub-pixels P1, P2, and P3. For example, the organic electroluminescent compound layers 130g, 130r, and 130b according to one embodiment of the present disclosure can minimize the impact of leakage current on the adjacent first to third sub-pixels P1, P2, and P3.

As described above, excitons are formed in an excitation process when holes and electrons are injected into the first electrodes 121, 122, and 123, which are anodes, and the second electrode 140, which is a cathode. In addition, excitons recombine in the EMI,s 132g, 132r, and 132b, and light is emitted due to energy from the excitons, when the first electrodes 121, 122, and 123 and the second electrode 140 are facing each other with the organic electroluminescent compound layers 130g, 130r, and 130b interposed therebetween. In particular, an organic light-emitting diode device displays an image by electrically controlling the amount of light generated from the EMLs 132g, 132r, and 132b.

Meanwhile, the second electrode 140 is formed on upper portions of the organic electroluminescent compound layers 130g, 130r, and 130b. The second electrode 140 can be a common layer commonly formed in the first to third sub-pixels P1, P2, and P3.

This second electrode 140 can be made of a transparent conductive material, a semi-transmissive conductive material, or a metal material with high reflectivity. When the display device is provided in a top emission type, the second electrode 140 can be formed of a transparent conductive material (TCO) such as ITO and IZO, which can transmit light, or a semi-transmissive conductive material such as magnesium (Mg), silver (Ag), or an alloy of Mg and Ag. When the display device is provided in a bottom emission type, the second electrode 140 can be formed of a metal material with high reflectivity, such as a stacked structure (Ti/Al/Ti) of Al and Ti, a stacked structure (ITO/Al/ITO) of Al and ITO, an Ag alloy, and a stacked structure (ITO/Ag alloy/ITO) of Ag alloy and ITO. The Ag alloy can be an alloy of silver (Ag), palladium (Pd), copper (Cu), and the like. Further, this second electrode 140 can be a cathode.

Referring to FIGS. 7 to 9, a first distance (cavity length) d1 between the first reflective electrode 117 and the second electrode 140 located in the first sub-pixel P1 can be less than a second distance (cavity length) d2 between the second reflective electrode 118 and the second electrode 140 located in the second sub-pixel P2, and be greater than a third distance (cavity length) d3 between the third reflective electrode 119 and the second electrode 140 located in the third sub-pixel P3.

However, in another embodiment, a length of the distances d1, d2, and d3 can vary. For example, in another embodiment, a length of the third distance d3 between the third reflective electrode 119 and the second electrode 140 located in the third sub-pixel P3 can be longer than a length of the first distance d1 between the first reflective electrode 117 and the second electrode 140 located in the first sub-pixel P1. Additionally, the length of the third distance d3 between the third reflective electrode 119 and the second electrode 140 located in the third sub-pixel P3 can be smaller than a length of the second distance d2 between the second reflective electrode 118 and the second electrode 140 located in the second sub-pixel P2.

In particular, a wavelength of each of red, green, and blue light can be said to be in the order red > green > blue, and the cavity length can also be said to be in the order red > green > blue. That is, the red light can have a transmittance peak at a wavelength band higher than that of green and blue light.

Thus, the first distance d1 between the first reflective electrode 117 and the second electrode 140 located in the first sub-pixel P1 can be less than the second distance d2 between the second reflective electrode 118 and the second electrode 140 located in the second sub-pixel P2, and be greater than the third distance d3 between the third reflective electrode 119 and the second electrode 140 located in the third sub-pixel P3. However, in another embodiment where the colors of the first sub-pixel to the third sub-pixel P1, P2, and P3, are changed, the respective distances between the second electrode 140 and the reflective electrodes 117, 118, and 119 can be changed to correspond to the color of each of the first sub-pixel to the third sub-pixel P1, P2, and P3.

The capping layer 160 and the encapsulation film 170 can be disposed on the second electrode 140. The capping layer 160 and the encapsulation film 170 are protective layers to protect the plurality of organic electroluminescent compound layers 130g, 130r, and 130b and the second electrode 140 from penetration of moisture (H2O) or other foreign substances from an outside.

The encapsulation film 170 serves to prevent oxygen or moisture from penetrating into the organic electroluminescent compound layers 130g, 130r, and 130b and the second electrode 140. To this end, the encapsulation film 170 can include at least one inorganic film and at least one organic film. Specifically, the encapsulation film 170 can include a first inorganic film and an organic film. In one embodiment, the encapsulation film 170 can further include a second inorganic film.

The first inorganic film is formed to cover the second electrode 140. The organic film is disposed on the first inorganic film, and can be formed at a distance sufficient to prevent particles from penetrating the first inorganic film and entering the organic electroluminescent compound layers 130g, 130r, and 130b and the second electrode 140. The second inorganic film is disposed to cover the organic film.

Each of the first and second inorganic films can be formed of silicon nitride, aluminum nitride, zirconium nitride, titanium nitride, hafnium nitride, tantalum nitride, silicon oxide, aluminum oxide, or titanium oxide. The first and second inorganic films be deposited by a chemical vapor deposition (CVD) method or an atomic layer deposition (ALD) method, but the present disclosure is not limited thereto.

The organic film can be formed of an acrylic resin, an epoxy resin, a phenolic resin, a polyamide resin, or a polyimide resin. The organic film can be formed by a vapor deposition method, a printing method, or a slit coating method, but not limited to these methods, and the organic film can be formed by an ink-jet method.

Hereinafter, a method for fabricating a display device according to one embodiment of the present disclosure will be described.

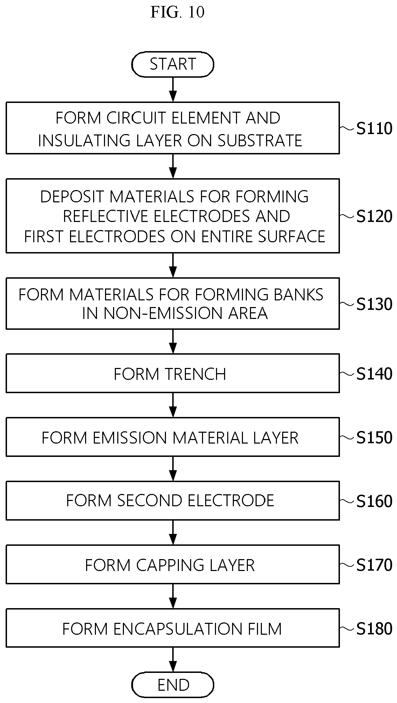

FIG. 10 is a flowchart illustrating a fabricating process of a display device according to one embodiment of the present disclosure.

Referring to FIG. 10, in the fabricating process of a display device according to one embodiment of the present disclosure, as a first operation (S110), a circuit element and an insulating layer are formed on a substrate. Next, as a second operation (S120), materials forming reflective electrodes and first electrodes are deposited on the insulating layer. The deposited materials can be patterned while or after being deposited on the insulating layer.

Next, as a third operation (S130), materials forming banks are formed in a non-emission area. The materials forming banks can be patterned while or after being formed in the non-emission area.

Next, as a fourth operation (S140), a trench is formed in the insulating layer between the reflective electrodes and between the first electrodes to separate the reflective electrodes and the first electrodes, thereby preventing leakage current. Next, as a fifth operation (S150), an organic electroluminescent compound layer including a hole layer, an emission material layer, and an electron layer is formed on the first electrode between the banks.

Next, as a sixth operation (S160), a second electrode is formed on the organic electroluminescent compound layer. Next, as a seventh operation (S170), a capping layer is formed on an upper portion of the second electrode. Next, as an eighth operation (S180), an encapsulation film is formed on the capping layer.

Meanwhile, the method for fabricating a display device according to one embodiment of the present disclosure will be described in more detail.

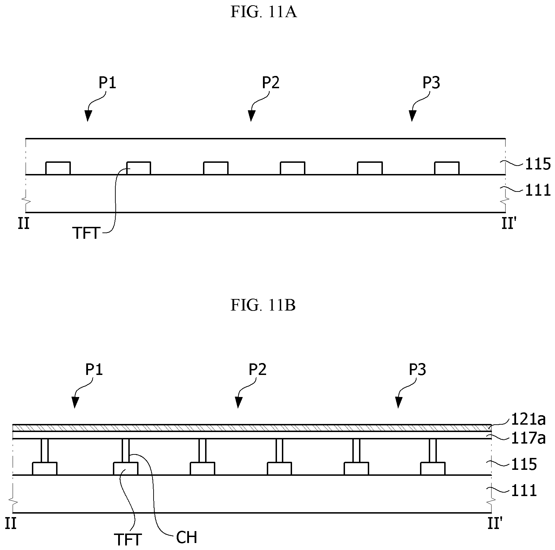

FIGS. 11A to 11H are cross-sectional views illustrating the method for fabricating a display device according to one embodiment of the present disclosure.

A first substrate 111 can be divided into a display area (DA in FIG. 2) and a non-display area (NDA in FIG. 2), and a pad area (PA in FIG. 2) in which pads are formed can be disposed in the non-display area NDA.

Data lines and gate lines intersecting the data lines are formed in the display area DA. In addition, pixels P that display an image in the form of a matrix can be formed in the display area DA in an intersection area of the data lines and the gate lines.

Each of the pixels P can include a first sub-pixel P1, a second sub-pixel P2, and a third sub-pixel P3. The first sub-pixel P1 can be provided to emit green light, the second sub-pixel P2 can be provided to emit red light, and the third sub-pixel P3 can be provided to emit blue light. However, the present disclosure is not necessarily limited thereto. Each of the pixels can further include a fourth sub-pixel that emits white (W) light. In addition, an arrangement sequence of the sub-pixels P1, P2, and P3 can be changed in various ways.

Referring to FIG. 3 described above, the first sub-pixel P1 can be divided into four first sub-areas P1-1, P1-2, P1-3, and P1-4, the second sub-pixel P2 can be divided into four second sub-areas P2-1, P2-2, P2-3, and P2-4, and the third sub-pixel P3 can be divided into four third sub-areas P3-1, P3-2, P3-3, and P3-4.

In the embodiment of the present disclosure, the first sub-pixel P1 is a green sub-pixel, the second sub-pixel P2 is a red sub-pixel, and the third sub-pixel P3 is a blue sub-pixel. In addition, the description will focus on two sub-areas of the four sub-areas of each of the sub-pixels P1, P2, and P3. For example, P1-1 and P1-2, P2-1 and P2-2, and P3-1 and P3-2. However, the description is not limited thereto.

The first substrate 111 can be made of glass or plastic, but is not necessarily limited thereto, and can be made of a semiconductor material such as a silicon wafer. The first substrate 111 can be made of a transparent material or an opaque material.

The display device according to one embodiment of the present disclosure can be provided in a top emission type in which emitted light is emitted toward an upper portion of the display device, but the present disclosure is not necessarily limited thereto. When the display device according to one embodiment of the present disclosure is provided in a top emission type in which emitted light is emitted toward an upper portion of the display device, the first substrate 111 can be made of an opaque material as well as a transparent material. Meanwhile, when the display device according to one embodiment of the present disclosure is provided in a bottom emission type in which emitted light is emitted toward a lower portion of the display device, the first substrate 111 can be made of a transparent material.

Referring to FIG. 11A, a circuit element including various signal lines, a thin-film transistor TFT, a capacitor, and the like are formed on the first substrate 111 for each of the first, second, and third sub-pixels P1, P2, and P3. The signal lines can include a gate line, a data line, a power line, and a reference line, and the thin-film transistor can include a switching thin-film transistor, the driving transistor TFT and a sensing thin-film transistor.

The switching thin-film transistor is configured to be switched according to the gate signal supplied to the gate line, and configured to supply the data voltage supplied from the data line to the driving thin-film transistor.

The driving transistor TFT is switched according to the data voltage supplied from the switching thin-film transistor to generate a data current from power supplied from the power line and serves to supply the generated data current to the first electrode 121.

The sensing thin-film transistor is configured to sense a threshold voltage deviation of the driving thin-film transistor, which is a cause of image degradation, and supply the current of the driving thin-film transistor to the reference line in response to a sensing control signal supplied from the gate line or a separate sensing line.

The capacitor is configured to maintain the data voltage supplied from the driving transistor TFT for one frame, and is connected to each of a gate terminal and a source terminal of the driving transistor TFT.

Next, an insulating layer 115 is formed on the circuit element including the driving transistor TFT. The insulating layer 115 can be formed of an inorganic film, for example, a SiOx film, a SiNx film, or a multilayer film of SiOx and SiNx, but the present disclosure is not necessarily limited thereto. The insulating layer 115 can be formed of an organic film, for example, an acrylic resin, an epoxy resin, a phenolic resin, a polyamide resin, a polyimide resin, or the like. Alternatively, the insulating layer 115 can be formed of a multilayer film that includes at least one inorganic film and at least one organic film.

Next, referring to FIG. 11B, a reflective electrode forming material layer 117a and a first electrode forming material layer 121a are stacked on the insulating layer 115. In addition, a contact hole CH can be formed between the driving transistor TFT and the reflective electrode forming material layer 117a.

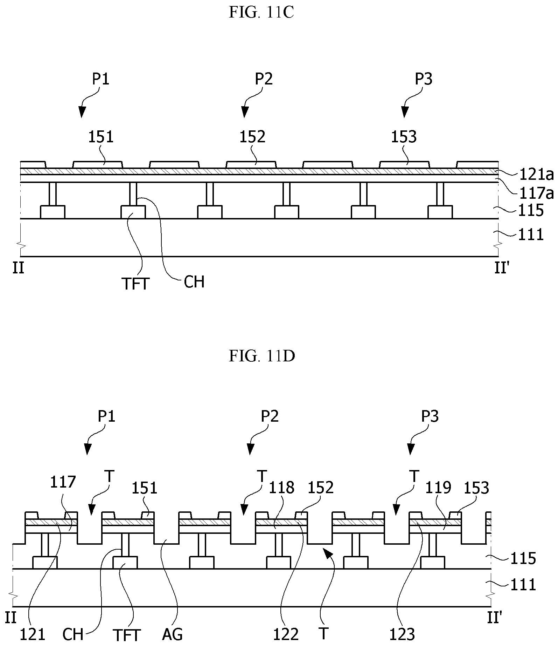

Following this, referring to FIG. 11C, a bank forming material layer is formed on an upper portion of the first electrode forming material layer 121a, and the bank forming material layer is selectively patterned to expose a portion of the first electrode forming material layer 121a. At this time, the exposed portion of the first electrode forming material layer 121a corresponds to the emission area EA.

Next, referring to FIG. 11D, the bank forming material layer, and the first electrode forming material layer 121a and the reflective electrode forming material layer 117a therebelow are sequentially etched to form banks 151, 152, and 153, first electrodes 121, 122, and 123, and first to third reflective electrodes 117, 118, and 119.

In this case, the first to third reflective electrodes 117, 118, and 119 and the first electrodes 121, 122, and 123 are formed on the insulating layer 115 disposed on the substrate 111 respectively for the first to third sub-pixels P1, P2, and P3.

The first sub-pixel P1 is divided into four sub-areas P1-1, P1-2, P1-3, and P1-4, and the first reflective electrode 117 and the first electrode 121 are formed in each of the four sub-areas P1-1, P1-2, P1-3, and P1-4. In addition, the second sub-pixel P2 is divided into four sub-areas P2-1, P2-2, P2-3, and P2-4, and the second reflective electrode 118 and the first electrode 122 are formed in each of the four sub-areas P2-1, P2-2, P2-3, and P2-4. In addition, the third sub-pixel P3 is divided into four sub-areas P3-1, P3-2, P3-3, and P3-4, and the third reflective electrode 119 and the first electrode 123 are formed in each of the four sub-areas P3-1, P3-2, P3-3, and P3-4

Here, the first to third reflective electrodes 117, 118, and 119 are configured as reflectors that reflect light emitted from organic electroluminescent compound layers 130g, 130r, and 130b, and can be formed of silver (Ag), aluminum (Al), and molybdenum (Mo), or alloys of the above materials, including an alloy of silver (Ag) and magnesium (Mg), which have high electrical conductivity and low work function. However, the first to third reflective electrodes 117, 118, and 119 can be formed of other materials as well.

The first electrodes 121, 122, and 123 are connected to the driving transistor TFT. Specifically, the first electrodes 121, 122, and 123 are connected to the source terminal or a drain terminal of the driving transistor TFT through a contact hole CH that passes through the insulating layer 115, so that a signal from the driving transistor TFT can be applied to the first electrodes 121, 122, and 123. The first electrodes 121, 122, and 123 can be formed of a transparent conductive metal material, a semi-transmissive conductive metal material, or a metal material with high reflectivity. However, the first to third reflective electrodes 117, 118, and 119 can be formed of other materials as well.

When the display device is provided in a top emission type, the first electrodes 121, 122, and 123 can be formed of a metal material with high reflectivity or a stacked structure of a metal material with high reflectivity and a transparent conductive material. For example, the first electrodes 121, 122, and 123 can be formed of a metal material with high reflectivity, such as a stacked structure (Ti/Al/Ti) of Al and Ti, a stacked structure (ITO/Al/ITO) of Al and ITO, an Ag alloy, and a stacked structure (ITO/Ag alloy/ITO) of Ag alloy and ITO. The Ag alloy can be an alloy of silver (Ag), palladium (Pd), copper (Cu), and the like. However, the material for the first to third reflective electrodes 117, 118, and 119 is not limited thereto.

When the display device is provided in a bottom emission type, the first electrodes 121, 122, and 123 can be formed of a transparent conductive material (TCO) such as ITO and IZO, which can transmit light, or a semi-transmissive conductive material such as magnesium (Mg), silver (Ag), or an alloy of Mg and Ag. These first electrodes 121, 122, and 123 can be anodes. However, the material for the first to third reflective electrodes 117, 118, and 119 is not limited thereto.

The first, second, and third banks 151, 152, and 153 are formed on the first electrodes 121, 122, and 123 and define the emission area EA in each of a plurality of first, second, and third sub-pixels P1, P2, and P3. That is, in each of the first to third sub-pixels P1, P2, and P3, the area in which the first, second, and third banks 151, 152, and 153 are not formed and the first electrodes 121, 122, and 123 are exposed. The exposed area is the emission area EA. On the other hand, an area outside of the emission area EA is a non-emission area.

In addition, the first bank 151 can define the emission area EA in each of first-first to first-fourth sub-areas P1-1, P1-2, P1-3, and P1-4 divided from the first sub-pixel P1. In the present embodiment, the first sub-pixel P1 is described by taking the green sub-pixel as an example, but the present disclosure is not limited thereto. In addition, the second bank 152 can define the emission area EA in each of second-first to second-fourth sub-areas P2-1, P2-2, P2-3, and P2-4 divided from the second sub-pixel P2. In the present embodiment, the second sub-pixel P2 is described by taking the red sub-pixel as an example, but the present disclosure is not limited thereto. In addition, the third bank 153 can define the emission area EA in each of third-first to third-fourth sub-areas P3-1, P3-2, P3-3, and P3-4 divided from the third sub-pixel P3. In the embodiment of the present disclosure, the third sub-pixel P3 is described by taking the blue sub-pixel as an example, but the present disclosure is not limited thereto.

The banks 151, 152, and 153 are formed at edges of the first electrodes 121, 122, and 123, respectively, so that it is possible to prevent a problem in which current is concentrated at the ends of the first electrodes 121, 122, and 123. When the current is concentrated at ends of the first electrodes 121, 122, and 123, a light emission efficiency can be reduced. Therefore, the banks 151, 152, and 153 being formed at edges of the first electrodes 121, 122, and 123 helps improve light emission efficiency.

These banks 151, 152, and 153 can be formed of an inorganic film, for example, a SiOx film, a SiNx film, or a multilayer film of SiOx and SiNx, but the present disclosure is not necessarily limited thereto. The banks 151, 152, and 153 can be formed of an organic film such as an acrylic resin, an epoxy resin, a phenolic resin, a polyamide resin, or a polyimide resin.

Trenches T are formed in the insulating layer 115, the first to third reflective electrodes 117, 118, and 119, the first electrodes 121, 122, and 123, and the banks 151, 152, and 153. The trench T can be formed between the sub-pixels P1, P2, and P3 to pass through the first to third reflective electrodes 117, 118, and 119, the first electrodes 121, 122, and 123, and the banks 151, 152, and 153 such that a portion of the insulating layer 115 is recessed, but the present disclosure is not necessarily limited thereto. The trench T can also be formed to pass through the insulating layer 115. Hereinafter, for convenience of description, the trench T can represent a portion that passes through the first electrodes 121, 122, and 123 and the banks 151, 152, and 153, or is recessed from or passes through the insulating layer 115. More specifically, the trenches T can be formed in a direction from upper surfaces of the banks 151, 152, and 153 toward the first substrate 111.

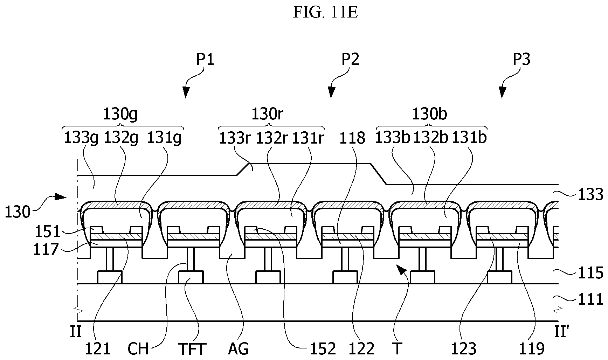

Next, referring to FIG. 11E, the organic electroluminescent compound layers 130g, 130r, and 130b are respectively formed on the first electrodes 121, 122, and 123. The organic electroluminescent compound layers 130g, 130r, and 130b can be white emission material layers that emit white light. In this case, the organic electroluminescent compound layers 130g, 130r, and 130b can be common layers commonly formed in the sub-pixels P1, P2, and P3.

As shown in FIGS. 5 and 7 described above, the organic electroluminescent compound layers 130g, 130r, and 130b respectively include hole layers 131g, 131r, and 131b each including a hole injection layer HIL and a hole transport layer HTL, EMI,s 132g, 132r, and 132b, and electron layers 133g, 133r, and 133b each including an electron transport layer ETL and an electron injection layer EIL.

The organic electroluminescent compound layer 130 includes the first organic electroluminescent compound layer 130g located in the first sub-pixel P1, a second organic electroluminescent compound layer 130r located in the second sub-pixel P2, and a third organic electroluminescent compound layer 130b located in the third sub-pixel P3.

The hole layer 131 includes a first hole layer 131g located in the first sub-pixel P1, a second hole layer 131r located in the second sub-pixel P2, and a third hole layer 131b located in the third sub-pixel P3.

The electron layer 133 is located on an upper portion of the EML 132 and is disposed on the entire surface of the first to third sub-pixels P1, P2, and P3. The electron layer 133 includes a first electron layer 133g located in the first sub-pixel P1, a second electron layer 133r located in the second sub-pixel P2, and a third electron layer 133b located in the third sub-pixel P3.

In order to vary cavity lengths d1, d2, and d3 between the second electrode 140 and the first to third reflective electrodes 117, 118, and 119 respectively located in the sub-pixels P1, P2, and P3, a thickness of the first electron layer 133g located in the first sub-pixel P1 can be formed to be less than a thickness of a second electron layer 133r located in the second sub-pixel P2, and to be greater than a thickness of a third electron layer 133b located in the third sub-pixel P3.

However, in other embodiments, the cavity lengths d1, d2, and d3 can have a different configuration. For example, a length of the third distance d3 between the third reflective electrode 119 and the second electrode 140 located in the third sub-pixel P3 can be longer than a length of the first distance d1 between the first reflective electrode 117 and the second electrode 140 located in the first sub-pixel P1. Additionally, the length of the third distance d3 between the third reflective electrode 119 and the second electrode 140 located in the third sub-pixel P3 can be smaller than a length of the second distance d2 between the second reflective electrode 118 and the second electrode 140 located in the second sub-pixel P2.

In this case, the electron transport layer ETL constituting the first to third electron layers 133g, 133r, and 133b can be formed to have a different thickness. Here, in the present embodiment, the case in which the electron transport layer ETL forming the electron layer is formed to have a different thickness is described by way of example, but the hole transport layer HTL forming the hole layer can be formed to have a different thickness.

In addition, the EML 132 , which is an emission material layer, includes a first EML 132g located in the first sub-pixel P1 and emitting green light, and a second EML 132r located in the second sub-pixel P2 and emitting red light, and a third EML 132b located in the third sub-pixel P3 and emitting blue light. However, the present disclosure is not necessarily limited thereto.

At this time, each of the first EML 132g, the second EML 132r, and the third EML 132b are formed by applying an FMM. For example, in order to form the first EML 132g in the green first sub-pixel P1 among the first to third sub-pixels P1, P2, and P3, a green emission material layer material can be deposited while an FMM is disposed on upper portions of the hole layers 131g of a plurality of first sub-pixels P1 corresponding to the green sub-pixel, thereby forming the first EML 132g in the green first sub-pixel P1. For the remaining second and third EMI,s 132r and 132b, the second and third EMI,s 132r and 132b can be formed in the red second sub-pixel P2 and the blue third sub-pixel P3 by depositing red and blue emission material layer materials while an FMM is disposed on upper portions of the second and third hole layers 131r and 131b of a plurality of second and third sub-pixels P2 and P3 corresponding to the red and blue sub-pixels.

As described above, since the plurality of first, second, and third sub-pixels P1, P2, and P3 are divided into four sub-areas P1-1, P1-2, P1-3, and P1-4, four sub-areas P2-1, P2-2, P2-3, and P2-4), and four sub-areas P3-1, P3-2, P3-3, and P3-4), respectively, the first, second, and third EMI,s 132g, 132r, and 132b can be easily formed using an FMM, thereby improving the degree of freedom of FMM fabrication by more than four times.

The first EML 132g formed in the first sub-pixel P1, the second EML 132r formed in the second sub-pixel P2, and the third EML 132b formed in the third sub-pixel P3 are disconnected from each other due to a stepped portion of the trench T, as shown in FIG. 7. Meanwhile, the first EML 132g formed in the first sub-pixel P1 and the second EML 132r formed in the second sub-pixel P2 are not in contact with each other at an upper portion of the trench T.

Since the first to third EMI,s 132g, 132r, and 132b respectively of the first to third sub-pixels P1, P2, and P3 are disconnected from each other inside the trench T, it is difficult for charges to move through the first to third EMI,s 132g, 132r, and 132b between the adjacent sub-pixels P1, P2, and P3. Accordingly, the trench T is able to effectively reduce leakage current between adjacent first to third sub-pixels P1, P2, and P3.

The organic electroluminescent compound layers 130g, 130r, and 130b according to one embodiment of the present disclosure can also minimize the impact of leakage current on the adjacent first to third sub-pixels P1, P2, and P3.

As described above, excitons are formed in an excitation process when holes and electrons are injected into the first electrodes 121, 122, and 123, which are anodes, and the second electrode 140, which is a cathode, recombine in the EMI,s 132g, 132r, and 132b, and light is emitted due to energy from the excitons, wherein the first electrodes 121, 122, and 123 and the second electrode 140 are facing each other with the organic electroluminescent compound layer 130 interposed therebetween. In particular, an organic light-emitting diode device displays an image by electrically controlling the amount of light generated from the EMI,s 132g, 132r, and 132b.

Next, the electron layer 133 is formed on the first substrate 111 including the EMI,s 132g, 132r, and 132b. In this case, the electron layer 133 is located on an upper portion of the EML 132 and is disposed on the entire surface of the first to third sub-pixels P1, P2, and P3. The electron layer 133 includes a first electron layer 133g located in the first sub-pixel P1, a second electron layer 133r located in the second sub-pixel P2, and a third electron layer 133b located in the third sub-pixel P3.

In order to vary cavity lengths d1, d2, and d3 between the second electrode 140 and the first to third reflective electrodes 117, 118, and 119 respectively located in the sub-pixels P1, P2, and P3, a thickness of the first electron layer 133g located in the first sub-pixel P1 can be less than a thickness of a second electron layer 133r located in the second sub-pixel P2, and be greater than a thickness of a third electron layer 133b located in the third sub-pixel P3.

In this case, the electron transport layer ETL constituting the first to third electron layers 133g, 133r, and 133b can be formed to have a different thickness. Here, in the present embodiment, the case in which the electron transport layer ETL forming the electron layer is formed to have a different thickness is described by way of example, but the hole transport layer HTL forming the hole layer can be formed to have a different thickness.

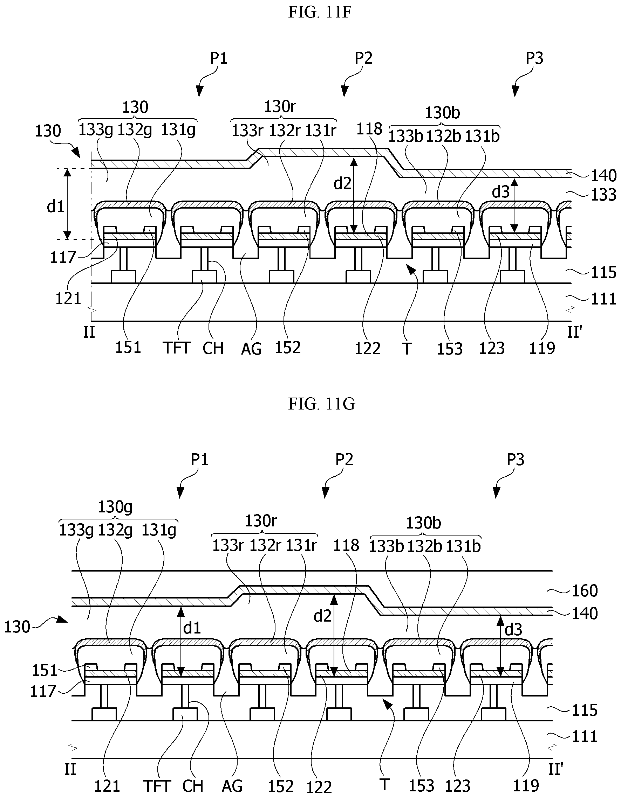

Next, referring to FIG. 11F, the second electrode 140 is formed on the organic electroluminescent compound layer 130. The second electrode 140 can be a common layer commonly formed in the first to third sub-pixels P1, P2, and P3. This second electrode 140 can be made of a transparent conductive metal material, a semi-transmissive conductive metal material, or a metal material with high reflectivity, but is not limited thereto.

When the display device is provided in a top emission type, the second electrode 140 can be formed of a transparent conductive material (TCO) such as ITO and IZO, which can transmit light, or a semi-transmissive conductive material such as magnesium (Mg), silver (Ag), or an alloy of Mg and Ag. When the display device is provided in a bottom emission type, the second electrode 140 can be formed of a metal material with high reflectivity, such as a stacked structure (Ti/Al/Ti) of Al and Ti, a stacked structure (ITO/Al/ITO) of Al and ITO, an Ag alloy, and a stacked structure (ITO/Ag alloy/ITO) of Ag alloy and ITO. The Ag alloy can be an alloy of silver (Ag), palladium (Pd), copper (Cu), and the like. In addition, the second electrode 140 can be a cathode.

In this case, a first cavity length d1 between the first reflective electrode 117 and the second electrode 140 located in the first sub-pixel P1 can be less than a second cavity length d2 between the second reflective electrode 118 and the second electrode 140 located in the second sub-pixel P2, and be greater than a third cavity length d3 between the third reflective electrode 119 and the second electrode 140 located in the third sub-pixel P3.

However, in other embodiments, the cavity lengths d1, d2, and d3 can have a different configuration. For example, a length of the third distance d3 between the third reflective electrode 119 and the second electrode 140 located in the third sub-pixel P3 can be longer than a length of the first distance d1 between the first reflective electrode 117 and the second electrode 140 located in the first sub-pixel P1. Additionally, the length of the third distance d3 between the third reflective electrode 119 and the second electrode 140 located in the third sub-pixel P3 can be smaller than a length of the second distance d2 between the second reflective electrode 118 and the second electrode 140 located in the second sub-pixel P2.

In particular, a wavelength of each of red, green, and blue light can be said to be in the order red > green > blue, and the cavity length can also be said to be in the order red > green > blue. That is, the red light can have a transmittance peak at a wavelength band higher than that of green and blue light.

Thus, the first cavity length d1 between the first reflective electrode 117 and the second electrode 140 located in the first sub-pixel P1 can be less than the second cavity length d2 between the second reflective electrode 118 and the second electrode 140 located in the second sub-pixel P2, and be greater than the third cavity length d3 between the third reflective electrode 119 and the second electrode 140 located in the third sub-pixel P3. However, in another embodiment where the colors of the first sub-pixel to the third sub-pixel P1, P2, and P3, are changed, the respective distances between the second electrode 140 and the reflective electrodes 117, 118, and 119 can be changed to correspond to the color of each of the first sub-pixel to the third sub-pixel P1, P2, and P3.

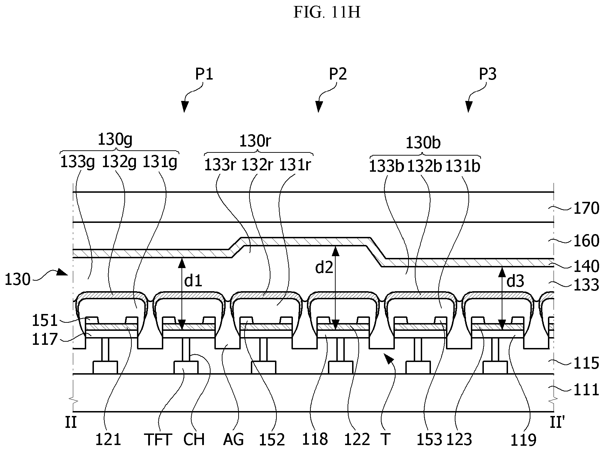

Next, referring to FIGS. 11G and 11H, a capping layer 160 and an encapsulation film 170 are formed on the second electrode 140. The capping layer 160 and the encapsulation film 170 are protective layers to protect the plurality of organic electroluminescent compound layers 130 and the second electrode 140 from penetration of moisture (H2O) or foreign substances from an outside.

The encapsulation film 170 serves to prevent oxygen or moisture from penetrating into the emission material layer 130 and the second electrode 140. To this end, the encapsulation film 170 can include at least one inorganic film and at least one organic film. Specifically, the encapsulation film 170 can include a first inorganic film and an organic film. In one embodiment, the encapsulation film 170 can further include a second inorganic film.

The first inorganic film is disposed to cover the second electrode 140. The organic film is formed on the first inorganic film, and can be formed at a distance sufficient to prevent particles from penetrating the first inorganic film and entering the organic electroluminescent compound layer 130 and the second electrode 140. The second inorganic film is disposed to cover the organic film.

Each of the first and second inorganic films can be formed of silicon nitride, aluminum nitride, zirconium nitride, titanium nitride, hafnium nitride, tantalum nitride, silicon oxide, aluminum oxide, or titanium oxide. The first and second inorganic films be deposited by a chemical vapor deposition (CVD) method or an atomic layer deposition (ALD) method, but the present disclosure is not limited thereto.

The organic film can be formed of an acrylic resin, an epoxy resin, a phenolic resin, a polyamide resin, or a polyimide resin. The organic film can be formed by a vapor deposition method, a printing method, or a slit coating method, but not limited to these methods, and the organic film can be formed by an ink-jet method.

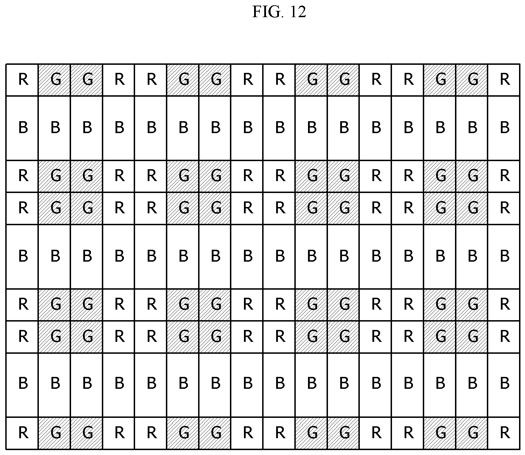

FIG. 12 is a plan view illustrating a case in which G-EMI,s are formed on sub-areas in the green sub-pixels by applying a green FMM in the display device according to one embodiment of the present disclosure.

Referring to FIG. 12, in the display device according to one embodiment of the present disclosure, an FMM is used to form G EMI,s (refer to 132g in FIG. 7) on four divided sub-areas P1-1, P1-2, P1-3, and P1-4 of each of a plurality of first sub-pixels P1, i.e., on the sub-areas in the green sub-pixel P1. At this time, the other second and third sub-pixels P2 and P3 are blocked by the FMM.

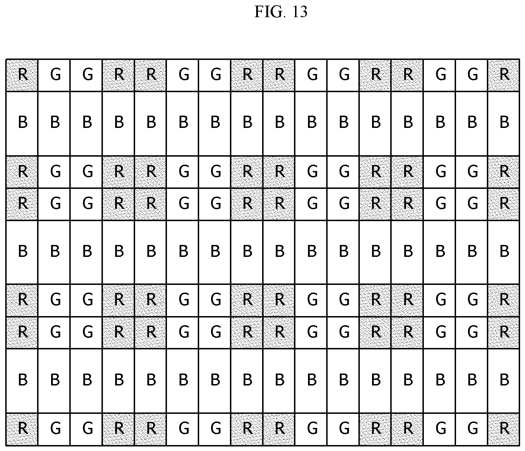

FIG. 13 is a plan view illustrating a case in which R-EMI,s are formed on sub-areas in the red sub-pixels by applying a red FMM in the display device according to one embodiment of the present disclosure.

Referring to FIG. 13, in the display device according to one embodiment of the present disclosure, an FMM is used to form R EMI,s (refer to 132r in FIG. 7) on four divided second sub-areas P2-1, P2-2, P2-3, and P2-4 of each of a plurality of second sub-pixels P2, i.e., on the sub-areas in the red sub-pixel P2. At this time, the other first and third sub-pixels P1 and P3 are blocked by the FMM.

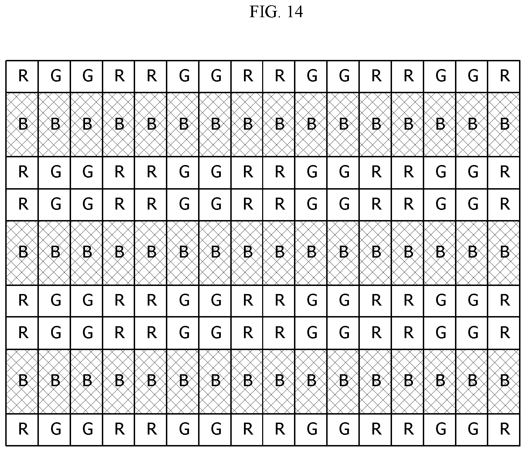

FIG. 14 is a plan view illustrating a case in which B-EMLs are formed on sub-areas in the blue sub-pixels by applying a blue FMM in the display device according to one embodiment of the present disclosure.

Referring to FIG. 14, in the display device according to one embodiment of the present disclosure, an FMM is used to form B EMI,s (refer to 132b in FIG. 7) on four divided sub-areas P3-1, P3-2, P3-3, and P3-4 of each of a plurality of third sub-pixels P3, i.e., on the sub-areas in the blue sub-pixel P3. At this time, the other first and second sub-pixels P1 and P2 are blocked by the FMM.

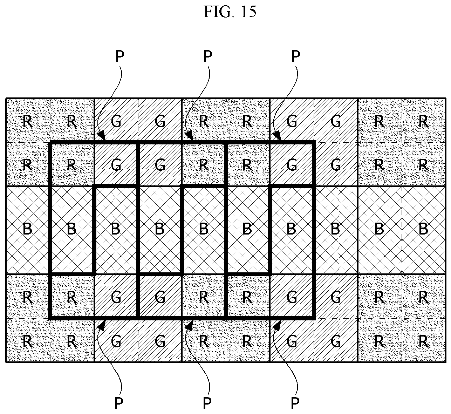

FIG. 15 is a plan view illustrating a case in which a pixel is configured with red, green, and blue sub-pixels in the display device according to one embodiment of the present disclosure.

Referring to FIG. 15, in the display device according to one embodiment of the present disclosure, a pixel P is implemented by combining green, red, and blue sub-areas in the first to third sub-pixels P1, P2, and P3 after forming the organic electroluminescent compound layer 130 by sequentially forming the EMI,s 132g, 132r, and 132b on the sub-areas in each of the first to third sub-pixels P1, P2, and P3. That is, each of a plurality of pixels P can be implemented as a combination of red, green, and blue sub-areas R, G, and B or can be implemented as a combination of green, red, and blue sub-areas G, R, and B.

In this case, the blue sub-area B has a larger area than the red sub-area R and the green sub-area G of the pixel P. This is because a brightness of the blue sub-area B is lower than the red sub-area R and the green sub-area G of the pixel P, and thus, the area of the blue sub-area B can be formed larger than the red and green sub-areas R and G to compensate for the brightness. However, in another embodiment, each of the green, red, and blue sub-areas G, R, and B can be the same.

Hereinafter, a display device according to another embodiment of the present disclosure will be described.

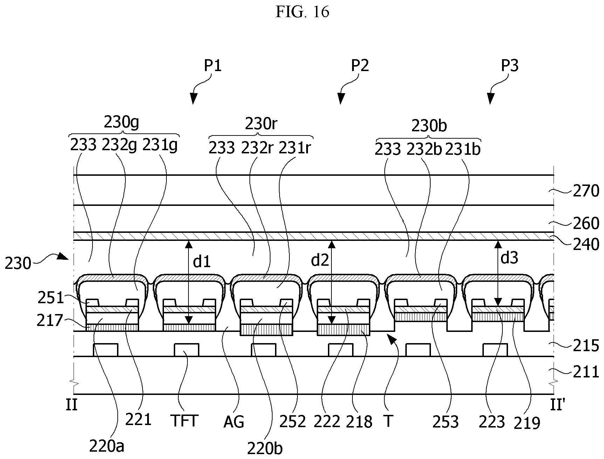

FIG. 16 is a cross-sectional view taken along line II-II' of FIG. 4, in another embodiment of the present disclosure.

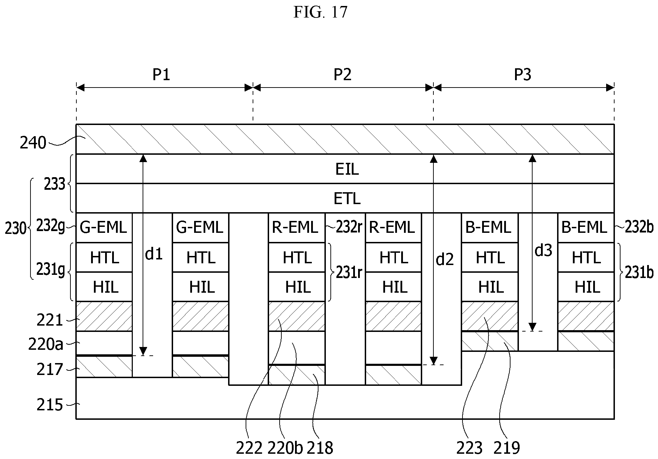

FIG. 17 is a cross-sectional view specifically illustrating an example of a configuration of a first electrode, an emission material layer, and a second electrode in two of four sub-areas of green, red, and green sub-pixels in the display device according to another embodiment of the present disclosure.

Each of pixels P can include a first sub-pixel P1, a second sub-pixel P2, and a third sub-pixel P3. The first sub-pixel P1 can be provided to emit green light, the second sub-pixel P2 can be provided to emit red light, and the third sub-pixel P3 can be provided to emit blue light. However, the present disclosure is not necessarily limited thereto. Each of the pixels can further include a fourth sub-pixel that emits white (W) light. In addition, an arrangement sequence of the sub-pixels P1, P2, and P3 can be changed in various ways.

Referring to FIG. 3 described above, the first sub-pixel P1 can be divided into four first sub-areas P1-1, P1-2, P1-3, and P1-4, the second sub-pixel P2 can be divided into four second sub-areas P2-1, P2-2, P2-3, and P2-4, and the third sub-pixel P3 can be divided into four third sub-areas P3-1, P3-2, P3-3, and P3-4.

In the embodiment of the present disclosure, the first sub-pixel P1 is a green sub-pixel, the second sub-pixel P2 is a red sub-pixel, and the third sub-pixel P3 is a blue sub-pixel. However, the present disclosure is not limited thereto.

Here, when a gate signal is input through a gate line, each of the sub-pixels P1, P2, and P3 supplies a predetermined current to a light-emitting element according to a data voltage of the data line. Accordingly, the light-emitting element of each of the sub-pixels P1, P2, and P3 can emit light with a predetermined brightness according to a predetermined current. In addition, a power voltage is supplied to a power line. The power line supplies the power voltage to each of the sub-pixels P1, P2, and P3.

Referring to FIGS. 16 and 17, a driving transistor TFT, an insulating layer 215, and first to third reflective electrodes 217, 218, and 219, auxiliary insulating layers 220a and 220b, first electrodes 221, 222, and 223, an organic electroluminescent compound layer 230, a second electrode 240, banks 251, 252, and 253, a capping layer 260, an encapsulation film 270, and trenches T are formed on one surface of a first substrate 211.

The first substrate 211 can be made of glass or plastic, but is not necessarily limited thereto, and can be made of a semiconductor material such as a silicon wafer. The first substrate 211 can be made of a transparent material or an opaque material.

The display device according to one embodiment of the present disclosure can be provided in a top emission type in which emitted light is emitted toward an upper portion of the display device, but the present disclosure is not necessarily limited thereto. When the display device according to one embodiment of the present disclosure is provided in a top emission type in which emitted light is emitted toward an upper portion of the display device, the first substrate 211 can be made of an opaque material as well as a transparent material. Meanwhile, when the display device according to one embodiment of the present disclosure is provided in a bottom emission type in which emitted light is emitted toward a bottom portion of the display device, the first substrate 211 can be made of a transparent material.

A circuit element that includes various signal lines, a thin-film transistor, a capacitor and the like is formed on the first substrate 211 for each of the sub-pixels P1, P2, and P3. The signal lines can include a gate line, a data line, a power line, and a reference line, and the thin-film transistor can include a switching thin-film transistor, the driving transistor TFT and a sensing thin-film transistor.

The switching thin-film transistor is switched according to the gate signal supplied to the gate line, and serves to supply the data voltage supplied from the data line to the driving thin-film transistor.

The driving transistor TFT is switched according to the data voltage supplied from the switching thin-film transistor to generate a data current from power supplied from the power line and serves to supply the generated data current to the first electrode 221.

The sensing thin-film transistor serves to sense a threshold voltage deviation of the driving thin-film transistor, which is a cause of image degradation, and supplies the current of the driving thin-film transistor to the reference line in response to a sensing control signal supplied from the gate line or a separate sensing line.

The capacitor serves to maintain the data voltage supplied from the driving transistor TFT for one frame, and is connected to each of a gate terminal and a source terminal of the driving transistor TFT.

The insulating layer 215 is formed on the circuit element that includes the driving transistor TFT. The insulating layer 215 can be formed of an inorganic film, for example, a SiOx film, a SiNx film, or a multilayer film of SiOx and SiNx, but the present disclosure is not necessarily limited thereto. The insulating layer 215 can be formed of an acrylic resin, an epoxy resin, a phenolic resin, a polyamide resin, a polyimide resin, or the like. Alternatively, the insulating layer 215 can be formed of a multilayer film that includes at least one inorganic film and at least one organic film.

Portions of the insulating layer 215 located at the first, second, and third sub-pixels P1, P2, and P3 are formed with different thicknesses. That is, a thickness of the portion of the insulating layer 215 located in the first sub-pixel P1 is formed to be greater than a thickness of the portion of the insulating layer 215 located in the second sub-pixel P2, and to be less than a thickness of the portion of the insulating layer 215 located in the third sub-pixel P3, and in this case, the portions of the insulating layer 215 with different thicknesses can be formed to have different thickness structures by selective etching using a halftone mask or other masks. However, the present disclosure is not limited thereto.

This is to ensure that cavity lengths d1, d2, and d3 between the first, second and third reflective electrodes 217, 218, and 219 and the second electrode 240 are formed differently. That is, a wavelength band of each of red, green, and blue light can be said to be in the order red > green > blue, and the cavity lengths d2, d1, and d3 can also be said to be in the order red > green > blue.

However, in other embodiments, the cavity lengths d1, d2, and d3 can have a different configuration. For example, a length of the third distance d3 between the third reflective electrode 219 and the second electrode 240 located in the third sub-pixel P3 can be longer than a length of the first distance d1 between the first reflective electrode 217 and the second electrode 240 located in the first sub-pixel P1. Additionally, the length of the third distance d3 between the third reflective electrode 219 and the second electrode 140 located in the third sub-pixel P3 can be smaller than a length of the second distance d2 between the second reflective electrode 118 and the second electrode 240 located in the second sub-pixel P2.

The first to third reflective electrodes 217, 218, and 219 are formed on the portions of the insulating layer 215 with different thicknesses, respectively. That is, the third reflective electrode 219 is formed on the area of the insulating layer 215 with the greatest thickness. The second reflective electrode 218 is formed on the area of the insulating layer 215 with the smallest thickness. In addition, the first reflective electrode 217 is formed on the area of the insulating layer 215 with an intermediate thickness.

In addition, the auxiliary insulating layers 220a and 220b are formed on the first and second reflective electrodes 217 and 218, respectively. In addition, the first electrodes 221, 222, and 223 are formed on the auxiliary insulating layers 220a and 220b and the third reflective electrode 219, respectively.

The first sub-pixel P1 is divided into four sub-areas P1-1, P1-2, P1-3, and P1-4, and the first electrode 221 is formed in each of the four sub-areas P1-1, P1-2, P1-3, and P1-4.

In addition, the second sub-pixel P2 is divided into four sub-areas P2-1, P2-2, P2-3, and P2-4, and the first electrode 222 is formed in each of the four sub-areas P2-1, P2-2, P2-3, and P2-4.

In addition, the third sub-pixel P3 is divided into four sub-areas P3-1, P3-2, P3-3, and P3-4, and the first electrode 223 is formed in each of the four sub-areas P3-1, P3-2, P3-3, and P3-4

The first to third reflective electrodes 217, 218, and 219 can be configured as reflectors that reflect light emitted from the organic electroluminescent compound layer 230, and can be formed of silver (Ag), aluminum (Al), and molybdenum (Mo), or alloys of the above materials, including an alloy of silver (Ag) and magnesium (Mg), which have high electrical conductivity and low work function.

The first electrodes 221, 222, and 223 are connected to the driving transistor TFT. Specifically, the first electrodes 221, 222, and 223 are connected to the source terminal or a drain terminal of the driving transistor TFT through a contact hole CH that passes through the insulating layer 215, so that a signal from the driving transistor TFT can be applied to the first electrodes 221, 222, and 223.

The first electrodes 221, 222, and 223 can be made of one of a transparent conductive metal material, a semi-transmissive conductive metal material, and a metal material with high reflectivity, but are not limited thereto.

When the display device is provided in a top emission type, the first electrodes 221, 222, and 223 can be formed of a metal material with high reflectivity or a stacked structure of a metal material with high reflectivity and a transparent conductive material. For example, the first electrodes 221, 222, and 223 can be formed of a metal material with high reflectivity, such as a stacked structure (Ti/Al/Ti) of Al and Ti, a stacked structure (ITO/Al/ITO) of Al and ITO, an Ag alloy, and a stacked structure (ITO/Ag alloy/ITO) of Ag alloy and ITO. The Ag alloy can be an alloy of silver (Ag), palladium (Pd), copper (Cu), and the like.

When the display device is provided in a bottom emission type, the first electrodes 221, 222, and 223 can be formed of a transparent conductive material (TCO) such as ITO and IZO, which can transmit light, or a semi-transmissive conductive material such as magnesium (Mg), silver (Ag), or an alloy of Mg and Ag. These first electrodes 221, 222, and 223 can be anodes.

The banks 251, 252, and 253 are formed on the first electrodes 221, 222, and 223 and define the emission area EA in each of a plurality of first, second, and third sub-pixels P1, P2, and P3. That is, in each of the first to third sub-pixels P1, P2, and P3, the area in which the banks 251, 252, and 253 are not formed and the first electrodes 221, 222, and 223 are exposed becomes the emission area EA. On the other hand, the area except for the emission area EA becomes a non-emission area.

In addition, referring to FIG. 3, the bank 251 can define the emission area EA in each of first-first to first-fourth sub-areas P1-1, P1-2, P1-3, and P1-4 divided from the first sub-pixel P1. In the present embodiment, the first sub-pixel P1 is described by taking the green sub-pixel as an example, but the present disclosure is not limited thereto.

In addition, referring to FIG. 3, the bank 252 can define the emission area EA in each of second-first to second-fourth sub-areas P2-1, P2-2, P2-3, and P2-4 divided from the second sub-pixel P2. In the present embodiment, the second sub-pixel P2 is described by taking the red sub-pixel as an example, but the present disclosure is not limited thereto. In addition, referring to FIG. 3, the bank 253 can define the emission area EA in each of third-first to third-fourth sub-areas P3-1, P3-2, P3-3, and P3-4 divided from the third sub-pixel P3. In the present embodiment, the third sub-pixel P3 is described by taking the blue sub-pixel as an example, but the present disclosure is not limited thereto.

The banks 251, 252, and 253 are formed at edges of the first electrodes 221, 222, and 223, respectively, so that it is possible to prevent a problem in which current is concentrated at the ends of the first electrodes 221, 222, and 223 to reduce light emission efficiency.

Meanwhile, the banks 251, 252, and 253 according to one embodiment of the present disclosure are formed such that the trenches T formed between the sub-pixels P1, P2, and P3 are exposed. That is, the banks 251, 252, and 253 are formed at edges of upper surfaces of the first electrodes 221, 222, and 223 formed in the sub-pixels P1, P2, and P3, respectively, however, the banks 251, 252, and 253 can or can not be formed on side surfaces of the first electrodes 221, 222, and 223, respectively.

These banks 251, 252, and 253 can be formed of an inorganic film, for example, a SiOx film, a SiNx film, or a multilayer film of SiOx and SiNx, but the present disclosure is not necessarily limited thereto. The banks 251, 252, and 253 can be formed of an organic film such as an acrylic resin, an epoxy resin, a phenolic resin, a polyamide resin, or a polyimide resin.

The trenches T are formed in the insulating layer 215, the auxiliary insulating layers 220a and 220b, the first electrodes 221, 222, and 223, and the banks 251, 252, and 253. The trenches T can be formed between the sub-pixels P1, P2, and P3 to pass through the first electrodes 221, 222, and 223 and the banks 251, 252, and 253 such that a portion of the insulating layer 215 is recessed, but the present disclosure is not necessarily limited thereto. The trench T can also be formed to pass through the insulating layer 215.

The first electrodes 221, 222, and 223 are formed on the auxiliary insulating layers 220a and 220b and the third reflective electrode 219. At this time, a metal material layer forming the first electrodes 221, 222, and 223 can be formed as a single layer across all of the first to third sub-pixels P1, P2, and P3 instead of being formed individually for each sub-pixel.

The banks 251, 252, and 253 are formed at edges of upper portions of the first electrodes 221, 222, and 223 to prevent the problem of current concentration at the ends of the first electrodes 221, 222, and 223 which reduces light emission efficiency.

The first electrodes 221, 222, and 223 can be respectively formed for the sub-pixels P1, P2, and P3. In addition, the banks 251, 252, and 253 can be formed at the edges of the upper surfaces of the first electrodes 221, 222, and 223 provided in the first to third sub-pixels P1, P2, and P3, respectively. That is, the trench T can also be formed in each of the first to third sub-pixels P1, P2, and P3, respectively divided into four first sub-areas P1-1 to P1-4, four second sub-areas P2-1 to P2-4, and four third sub-areas P3-1 to P3-4.

The trench T separates the first electrodes 221, 222, and 223 respectively formed in the first to third sub-pixels P1, P2, and P3 from each other to expose the side surface of each of the first electrodes 221, 222, and 223. In this case, the trench T can have a width equal to a separation distance between the first electrodes 221, 222, and 223. However, the present disclosure is not necessarily limited thereto.

In addition, the trench T separates the banks 251, 252, and 253 respectively formed in the first to third sub-pixels P1, P2, and P3 from each other to expose the side surface of each of the banks 251, 252, and 253.

The width of the trench T can be determined in consideration of a thickness and a deposition method of the organic electroluminescent compound layer 230.

The trench T can be formed between the first sub-pixel P1 and the second sub-pixel P2, and a hole layer 231g, an emission material layer 232g that is an EMI,, and an electron layer 233g of the organic electroluminescent compound layer 230 can be sequentially stacked in the trench T. For example, when the width of the trench T is formed to be less than 0.09 µm, a first hole layer 231g stacked in the first sub-pixel P1 and a second hole layer 231r stacked in the second sub-pixel P2 can be in contact with each other at an upper portion of the trench T. Due to this, a first EML 232g stacked on the first hole layer 231g in the first sub-pixel P1 is connected to that in the second sub-pixel P2, causing a leakage current between the adjacent sub-pixels P1 and P2.

In order to prevent the first hole layer 231g stacked in the first sub-pixel P1 and the second hole layer 231r stacked in the second sub-pixel P2 from coming into contact with each other at the upper portion of the trench T, in the display device according to another embodiment of the present invention, a width of the trench T can be formed to be greater than or equal to 0.09 µm. However, the present disclosure is not necessarily limited thereto.

On the other hand, when the width of the trench T is formed to be large, the second electrodes 240 of the adjacent sub-pixels can be disconnected from each other in the trench T without being connected to each other. For example, when the width of the trench T is formed to be greater than or equal to 0.20 µm, the second electrode 240 stacked in the first sub-pixel P1 and the second electrode 240 stacked in the second sub-pixel P2 can be disconnected from each other by the trench T.

The organic electroluminescent compound layer 230 is formed on the first electrodes 221, 222, and 223. The organic electroluminescent compound layer 230 can be a white emission material layer that emits white light. In this case, the organic electroluminescent compound layer 230 can be a common layer commonly formed in the sub-pixels P1, P2, and P3.

As shown in FIG. 17, organic electroluminescent compound layers 230g, 230r, and 230b respectively include hole layers 231g, 231r, and 231b each including a hole injection layer HIL and a hole transport layer HTL, and EMI,s 232g, 232r, and 232b, and include an electron layer 233 including an electron transport layer ETL and an electron injection layer EIL.

The organic electroluminescent compound layer 230 includes a first organic electroluminescent compound layer 230g located in the first sub-pixel P1, a second organic electroluminescent compound layer 230r located in the second sub-pixel P2, and a third organic electroluminescent compound layer 230b located in the third sub-pixel P3.

In addition, the hole layer 231 includes a first hole layer 231g located in the first sub-pixel P1, a second hole layer 231r located in the second sub-pixel P2, and a third hole layer 231b located in the third sub-pixel P3.

The electron layer 233 is located on upper portions of the EMI,s 232g, 232r, and 232b, and is disposed on the entire surface of the first to third sub-pixels P1, P2, and P3.

Referring to FIGS. 16 and 17, in order to vary the cavity lengths d1, d2, and d3 between the second electrode 240 and the first to third reflective electrodes 217, 218, and 219 respectively located in the sub-pixels P1, P2, and P3, a thickness of the insulating layer 215 located in the first sub-pixel P1 can be formed to be less than a thickness of the insulating layer 215 located in the second sub-pixel P2, and to be greater than a thickness of the insulating layer 215 located in the third sub-pixel P3.

In addition, the EML includes the first EML 232g located in the first sub-pixel P1 and emitting green light, and a second EML 232r located in the second sub-pixel P2 and emitting red light, and a third EML 232b located in the third sub-pixel P3 and emitting blue light. However, the present disclosure is not necessarily limited thereto.

In addition, the EMI,s 232g, 232r, and 232b are formed by applying an FMM. For example, in order to form the first EML 232g in the green first sub-pixel P1 among the first to third sub-pixels P1, P2, and P3, a green emission material layer material is deposited while an FMM is disposed on upper portions of the first hole layers 231g of a plurality of first sub-pixels P1 corresponding to the green sub-pixel, thereby forming the first EML 232g in the green first sub-pixel P1.

At this time, since each of the plurality of first sub-pixels P1 is divided into four sub-areas P1-1, P1-2, P1-3, and P1-4, the first EML 232g can be easily formed using the FMM, thereby improving the degree of freedom of FMM fabrication by more than four times.

Meanwhile, the red second sub-pixel P2 and the blue third sub-pixel P3 can also be formed by using FMMs separately for the red second EML 232r and the blue third EML 232b, respectively. The red second sub-pixel P2 and the blue third sub-pixel P3 can be formed similarly to the green first sub-pixel P1.

Accordingly, in the case of each of a plurality of second sub-pixels P2 and each of a plurality of third sub-pixels P3, which are divided into four sub-areas P2-1, P2-2, P2-3, and P2-4 and four sub-areas P3-1, P3-2, P3-3, and P3-4, FMMs can be used to form the second and third EMI,s 232r and 232b, thereby improving the degree of freedom of FMM fabrication by more than four times.

The first EML 232g formed in the first sub-pixel P1, the second EML 232r formed in the second sub-pixel P2, and the third EML 232b formed in the third sub-pixel P3 are disconnected from each other due to a stepped portion of the trench T.

Meanwhile, the first EML 232g formed in the first sub-pixel P1 and the second EML 232r formed in the second sub-pixel P2 are not in contact with each other at the upper portion of the trench T.

Since the first to third EMI,s 232g, 232r, and 232b respectively of the first to third sub-pixels P1, P2, and P3 are disconnected from each other inside the trench T, it is difficult for charges to move through the first to third EMI,s 232g, 232r, and 232b between the adjacent sub-pixels P1, P2, and P3.

The organic electroluminescent compound layer 230 according to another embodiment of the present disclosure can minimize the impact of the leakage current on the adjacent first to third sub-pixels P1, P2, and P3.

As described above, excitons are formed in an excitation process when holes and electrons are injected into the first electrodes 221, 222, and 223, which are anodes, and the second electrode 240, which is a cathode, recombine in the EMI,s 232g, 232r, and 232b, and light is emitted due to energy from the excitons, wherein the first electrodes 221, 222, and 223 and the second electrode 240 are facing each other with the organic electroluminescent compound layer 230 interposed therebetween. In particular, an organic light-emitting diode device displays an image by electrically controlling the amount of light generated from the EMI,s 232g, 232r, and 232b.

Meanwhile, the second electrode 240 is formed on the organic electroluminescent compound layer 230. The second electrode 240 can be a common layer commonly formed in the first to third sub-pixels P1, P2, and P3.

A first cavity length d1 between the first reflective electrode 217 and the second electrode 240 located in the first sub-pixel P1 can be less than a second cavity length d2 between the second reflective electrode 218 and the second electrode 240 located in the second sub-pixel P2, and be greater than a third cavity length d3 between the third reflective electrode 219 and the second electrode 240 located in the third sub-pixel P3.

However, in other embodiments, the cavity lengths d1, d2, and d3 can have a different configuration. For example, a length of the third distance d3 between the third reflective electrode 219 and the second electrode 240 located in the third sub-pixel P3 can be longer than a length of the first distance d1 between the first reflective electrode 217 and the second electrode 240 located in the first sub-pixel P1. Additionally, the length of the third distance d3 between the third reflective electrode 219 and the second electrode 240 located in the third sub-pixel P3 can be smaller than a length of the second distance d2 between the second reflective electrode 218 and the second electrode 240 located in the second sub-pixel P2.

In particular, a wavelength of each of red, green, and blue light can be said to be in the order red > green > blue, and the cavity length can also be said to be in the order red > green > blue. That is, the red light can have a transmittance peak at a wavelength band higher than that of green and blue light. However, in another embodiment where the colors of the first sub-pixel to the third sub-pixel P1, P2, and P3, are changed, the respective distances between the second electrode 140 and the reflective electrodes 217, 218, and 219 can be changed to correspond to the color of each of the first sub-pixel to the third sub-pixel P1, P2, and P3.

Thus, the first cavity length d1 between the first reflective electrode 217 and the second electrode 240 located in the first sub-pixel P1 can be less than the second cavity length d2 between the second reflective electrode 218 and the second electrode 240 located in the second sub-pixel P2, and be greater than the third cavity length d3 between the third reflective electrode 219 and the second electrode 240 located in the third sub-pixel P3.

The capping layer 260 and the encapsulation film 270 can be formed on the second electrode 240. The capping layer 260 and the encapsulation film 270 are protective layers to protect the plurality of organic electroluminescent compound layers 230 and the second electrode 240 from penetration of moisture (H2O) or foreign substances from an outside.

The display device according to embodiments of the present disclosure can be applied to mobile apparatuses, video phones, smart watches, watch phones, wearable apparatuses, foldable apparatuses, rollable apparatuses, bendable apparatuses, flexible apparatuses, curved apparatuses, sliding apparatuses, variable apparatuses, electronic organizers, electronic books, portable multimedia players (PMPs), personal digital assistants (PDAs), MP3 players, mobile medical apparatuses, desktop personal computers (PCs), laptop PCs, netbook computers, workstations, navigation apparatuses, automotive display apparatuses, theater displays, televisions (TVs), wallpaper apparatuses, signage apparatuses, notebook computers, monitors, cameras, camcorders, home appliances, and the like. In addition, a display device manufactured through a light-emitting element transfer stamp and a light-emitting element transfer method using a transfer stamp according to one or more embodiments of the present disclosure can be applied to an organic light-emitting lighting device or an inorganic light-emitting lighting device, but is not limited thereto. In addition, the display device can be applied to any device that uses a display.

A display device according to one or more embodiments of the present disclosure can be described as follows.

A display device according to one or more embodiments of the present disclosure includes a substrate in which a first sub-pixel, a second sub-pixel, and a third sub-pixel, each of which is divided into at least two sub-areas, are defined, a plurality of thin-film transistors respectively disposed to correspond to the at least two sub-areas in each of the first to third sub-pixels, an insulating layer provided on the plurality of thin-film transistors, a plurality of first electrodes disposed on the insulating layer to correspond to the at least two sub-areas in each of the first to third sub-pixels and respectively connected to the plurality of thin-film transistors, a trench located between the sub-areas divided in each of the first to third sub-pixels, an organic electroluminescent compound layer disposed on the first electrodes, and a second electrode formed on the organic electroluminescent compound layer, wherein the at least two sub-areas in each of the first to third sub-pixels have the same color.

A bank can be further disposed at an edge of the first electrode disposed on the at least two sub-areas divided in each of the first to third sub-pixels.

A reflective electrode can be further disposed below the first electrode disposed in each of the at least two sub-areas in each of the first to third sub-pixels.

The first sub-pixel can be a green sub-pixel, the second sub-pixel can be a red sub-pixel, and the third sub-pixel can be a blue sub-pixel.

A cavity length d1 between the reflective electrode of the first sub-pixel and the second electrode can be less than a cavity length d2 between the reflective electrode of the second sub-pixel and the second electrode, and greater than a cavity length d3 between the reflective electrode of the third sub-pixel and the second electrode.

A first thickness of the electron layer located in the first sub-pixel can be less than a second thickness of the electron layer located in the second sub-pixel and greater than a third thickness of the electron layer located in the third sub-pixel.

A thickness of the insulating layer located below the reflective electrode of the first sub-pixel can be greater than a thickness of the insulating layer located below the reflective electrode of the second sub-pixel and less than a thickness of the insulating layer located below the reflective electrode of the third sub-pixel.

The organic electroluminescent compound layer can include hole layers respectively formed on the first electrodes, EMI,s respectively formed on the hole layers, and an electron layer formed on the substrate including the EMI,s.

The first to third emission material layers can be respectively formed on the first to third hole layers in the sub-areas of the first to third sub-pixels with the trench therebetween.

The at least two sub-areas can include four sub-areas.

A display device according to one or more embodiments of the present disclosure includes a substrate in which a first sub-pixel, a second sub-pixel, and a third sub-pixel, each of which is divided into at least two sub-areas, are defined, an insulating layer provided on the substrate, a reflective electrode provided on the insulating layer, a plurality of first electrodes disposed on the insulating layer to correspond to the at least two sub-areas in each of the first to third sub-pixels, a trench located between the at least two sub-areas divided in each of the first to third sub-pixels, an organic electroluminescent compound layer disposed on the first electrodes, and a second electrode formed on the organic electroluminescent compound layer, wherein the at least two sub-areas in each of the first to third sub-pixels have the same color.

A reflective electrode can be further disposed below the first electrode disposed in each of the at least two sub-areas in each of the first to third sub-pixels.

The organic electroluminescent compound layer can include hole layers respectively formed on the first electrodes, EMI,s respectively formed on the hole layers, and an electron layer formed on the substrate including the EMI,s.

The first sub-pixel can be a green sub-pixel, the second sub-pixel can be a red sub-pixel, and the third sub-pixel can be a blue sub-pixel.

A distance d1 between the reflective electrode of the first sub-pixel and the second electrode can be less than a distance d2 between the reflective electrode of the second sub-pixel and the second electrode, and greater than a distance d3 between the reflective electrode of the third sub-pixel and the second electrode.

The at least two sub-areas can include four sub-areas.

A method for fabricating a display device according to one or more embodiments of the present disclosure includes preparing a substrate in which a first sub-pixel, a second sub-pixel, and a third sub-pixel, each of which is divided into at least two sub-areas, are defined, forming a plurality of first electrodes respectively disposed to correspond to the at least two sub-areas in each of the first to third sub-pixels, forming first to third hole layers on the plurality of first electrodes located in the sub-areas in the first to third sub-pixels, respectively, sequentially forming first to third EMLs on the first to third hole layers located on the sub-areas in the first to third sub-pixels using first to third FMMs, forming an electron layer on the substrate including the first to third EMI,s, and forming a second electrode on the electron layer.

A cavity length d1 between the reflective electrode of the first sub-pixel and the second electrode can be less than a cavity length d2 between the reflective electrode of the second sub-pixel and the second electrode, and greater than a cavity length d3 between the reflective electrode of the third sub-pixel and the second electrode.

The at least two sub-areas can include four sub-areas.

The sub-areas in the first to third sub-pixels can be formed through the same process, and the at least two sub-areas in the first to third sub-pixels can have the same color.

Since the content of the present disclosure described in the problems to be solved, the problem-solving means, and effects does not specify essential features of the claims, the scope of the claims is not limited to matters described in the content of the disclosure.

According to the present disclosure, a degree of fabrication freedom of an FMM can be improved by ensuring that an anode area of a thin-film transistor corresponds to an emission area of an EML in a ratio greater than or equal to 1:2 to overcome the manufacturing technology and mass productivity of the FMM, which are necessary for implementing an ultra-high-resolution display.

According to the present disclosure, the difficulty of a mask fabrication process can be reduced by increasing an opening area of an FMM by at least two times, and mass productivity can be improved by reducing mask clogging problems through the increased opening area.

According to the present disclosure, self-pixelization is achievable with one sub-pixel size by using a trench, even when the area of an emission material layer is four times larger.

The effects of the present disclosure are not limited to the effects mentioned above, and other effects not mentioned can be clearly understood by those skilled in the art from the description of the claims.

While the embodiments have been described in detail above with reference to the accompanying drawings, the present disclosure is not necessarily limited to these embodiments, and various changes and modifications can be made without departing from the technical spirit of the present invention. Accordingly, the embodiments disclosed herein are to be considered descriptive and not restrictive of the technical spirit of the present disclosure, and the scope of the technical spirit of the present disclosure is not limited by these embodiments. Therefore, the above-described embodiments should be understood to be exemplary and not limiting in any embodiment.

Also disclosed herein are the following numbered clauses:
1. A display device comprising:
   a substrate in which a first sub-pixel, a second sub-pixel, and a third sub-pixel are disposed, each of the first to third sub-pixels being divided into at least two sub-areas;
   an insulating layer disposed on the substrate;
   a reflective electrode disposed on the insulating layer;
   a plurality of first electrodes disposed on the insulating layer and configured to correspond to the at least two sub-areas in each of the first to third sub-pixels;
   a trench located between the at least two sub-areas divided in each of the first to third sub-pixels;
   an organic electroluminescent compound layer disposed on the plurality of first electrodes; and
   a second electrode disposed on the organic electroluminescent compound layer,
   wherein the at least two sub-areas in the first sub-pixel have a same color, the at least two sub-areas in the second sub-pixel have a same color different than the color of the at least two sub-areas in the first sub-pixel, and the at least two sub-areas in the third sub-pixel have a same color different than the color of the two sub-areas in the first sub-pixel and the second sub-pixel.
2. The display device of clause 1, wherein the first sub-pixel is a green sub-pixel,
   wherein the second sub-pixel is a red sub-pixel, and
   wherein the third sub-pixel is a blue sub-pixel.
3. The display device of clause 2, wherein a cavity length between the reflective electrode of the first sub-pixel and the second electrode is less than a cavity length between the reflective electrode of the second sub-pixel and the second electrode, and greater than a cavity length between the reflective electrode of the third sub-pixel and the second electrode.
4. The display device of any preceding clause, wherein the at least two sub-areas of the first to third sub-pixels include four sub-areas.
5. The display device of any preceding clause wherein the organic electroluminescent compound layer includes a plurality of hole layers respectively disposed on the plurality of first electrodes, a plurality of emission material layers (EMI,s) respectively disposed on the hole layers, and an electron layer disposed on the substrate including the plurality of EMI,s.
6. A display device comprising:
   a substrate in which a first sub-pixel, a second sub-pixel, a third sub-pixel and a fourth sub-pixel are disposed, each of the first to fourth sub-pixels being divided into at least two sub-areas;
   a plurality of thin-film transistors respectively disposed to correspond to the sub-areas in each of the first to fourth sub-pixels;
   an insulating layer disposed on the plurality of thin-film transistors; and
   a plurality of trenches located between the sub-areas divided in each of the first to fourth sub-pixels, and located between adjacent sub-pixels of the first to fourth sub-pixels.
7. The display device of claim 6, wherein the sub-areas in the first sub-pixel have a same color,
   wherein the sub-areas in the second sub-pixel have a same color,
   wherein the sub-areas in the third sub-pixel have a same color, and
   wherein the sub-areas in the fourth sub-pixel have a same color.
8. The display device of claim 6 or 7, further comprising:
   a plurality of first electrodes disposed on the insulation layer; and
   a plurality of banks disposed on the plurality of electrodes,
   wherein a bank of the plurality of banks is disposed at an end portion of each of the first electrodes, and
   wherein the plurality of banks prevent a concentration of current in the end portions of the first electrodes.
9. The display device of claim 8, wherein an area between adjacent banks disposed on one of the first electrodes of the plurality of electrodes is an emission area.

## Claims

1. A display device comprising:
a substrate in which a first sub-pixel, a second sub-pixel, and a third sub-pixel are disposed, each of the first to third sub-pixels being divided into at least two sub-areas;
a plurality of thin-film transistors respectively disposed to correspond to the at least two sub-areas in each of the first to third sub-pixels;
an insulating layer disposed on the plurality of thin-film transistors;
a plurality of first electrodes disposed on the insulating layer, configured to correspond to the at least two sub-areas in each of the first to third sub-pixels, and respectively connected to the plurality of thin-film transistors;
a trench located between the at least two sub-areas in each of the first to third sub-pixels;
an organic electroluminescent compound layer disposed on the plurality of first electrodes; and
a second electrode disposed on the organic electroluminescent compound layer,
wherein the at least two sub-areas in the first sub-pixel have a same color, the at least two sub-areas in the second sub-pixel have a same color different than the color of the two sub-areas in the first sub-pixel, and the at least two sub-areas in the third sub-pixel have a same color different than the color of the at least two sub-areas in the first sub-pixel and the second sub-pixel.

2. The display device of claim 1, further comprising a plurality of banks,
wherein a bank of the plurality of banks is disposed at an edge of the first electrode corresponding to the at least two sub-areas divided in each of the first to third sub-pixels.

3. The display device of claim 1 or 2, further comprising a reflective electrode disposed below the first electrode corresponding to the at least two sub-areas in each of the first to third sub-pixels.

4. The display device of claim 3, wherein the first sub-pixel is a green sub-pixel,
wherein the second sub-pixel is a red sub-pixel, and
wherein the third sub-pixel is a blue sub-pixel.

5. The display device of claim 4, wherein a cavity length between the reflective electrode of the first sub-pixel and the second electrode is less than a cavity length between the reflective electrode of the second sub-pixel and the second electrode, and greater than a cavity length between the reflective electrode of the third sub-pixel and the second electrode.

6. The display device of any preceding claim, wherein the organic electroluminescent compound layer includes a plurality of hole layers respectively disposed on the plurality of first electrodes, a plurality of emission material layers (EMI,s) respectively disposed on the plurality of hole layers, and an electron layer disposed on the substrate including the plurality of EMI,s.

7. The display device of claim 5, wherein a first thickness of a portion of the electron layer located in the first sub-pixel is less than a second thickness of a portion of the electron layer located in the second sub-pixel and greater than a third thickness of a portion of the electron layer located in the third sub-pixel.

8. The display device of claim 5, wherein a thickness of a portion of the insulating layer located below the reflective electrode of the first sub-pixel is greater than a thickness of a portion of the insulating layer located below the reflective electrode of the second sub-pixel and less than a thickness of a portion of the insulating layer located below the reflective electrode of the third sub-pixel.

9. The display device of any of claims 6 to 8, wherein first to third EMI,s of the plurality of EMI,s are respectively formed on a first to third hole layers of the plurality of hole layers in the at least two sub-areas of the first to third sub-pixels with the trench disposed therebetween.

10. The display device of any of claims 4 to 9, wherein the at least two sub-areas of the first to third sub-pixels include four sub-areas.

11. A method for fabricating a display device, the method comprising:
preparing a substrate in which a first sub-pixel, a second sub-pixel, and a third sub-pixel are disposed, each of the first to third sub-pixels being divided into at least two sub-areas;
forming a plurality of first electrodes respectively disposed to correspond to the at least two sub-areas in each of the first to third sub-pixels;
forming first to third hole layers on the plurality of first electrodes located in the at least two sub-areas in the first to third sub-pixels, respectively;
sequentially forming first to third emission material layers (EMI,s) on the first to third hole layers located on the at least two sub-areas in the first to third sub-pixels using first to third fine metal masks (FMMs);
forming an electron layer on the substrate including the first to third EMI,s; and
forming a second electrode on the electron layer.

12. The method of claim 11, wherein a cavity length between a reflective electrode of the first sub-pixel and the second electrode is less than a cavity length between a reflective electrode of the second sub-pixel and the second electrode, and greater than a cavity length between a reflective electrode of the third sub-pixel and the second electrode.

13. The method of claim 11 or 12, wherein the at least two sub-areas of the first to third sub-pixels include four sub-areas.

14. The method of any of claims 11 to 13, wherein the at least two sub-areas in each of the first to third sub-pixels are formed by a same process, and
wherein the at least two sub-areas in the first sub-pixel have a same color, the at least two sub-areas in the second sub-pixel have a same color different than the color of the two sub-areas in the first sub-pixel, and the at least two sub-areas in the third sub-pixel have a same color different than the color of the at least two sub-areas in the first sub-pixel and the second sub-pixel.
